Europäisches Patentamt

European Patent Office

Office européen des brevets

(11) Veröffentlichungsnummer: **0 582 275 A1**

## EUROPÄISCHE PATENTANMELDUNG

(21) Anmeldenummer: **93112427.5**

(22) Anmeldetag: **03.08.93**

(51) Int. Cl.⁵: **H04B 10/18**

(30) Priorität: **07.08.92 DE 4226187**

(43) Veröffentlichungstag der Anmeldung:
**09.02.94 Patentblatt 94/06**

(84) Benannte Vertragsstaaten:
**DE FR GB NL**

(71) Anmelder: **SIEMENS AKTIENGESELLSCHAFT**
**Wittelsbacherplatz 2**
**D-80333 München(DE)**

(72) Erfinder: **Noè, Reinhold, Dr. Prof.**
**Helmerner Weg 2**
**D-33100 Paderborn(DE)**

(54) **Verfahren zur Erzeugung eines verzerrungsfreien frequenzmodulierten Signals und Einrichtung zur Durchführung eines solchen Verfahrens.**

(57) Verfahren zur Erzeugung eines verzerrungsfreien frequenzmodulierten optischen Signals, wobei dieses Signal von einem mit einer modulierenden Spannung angesteuerten optischen Halbleiterlaser in Abhängigkeit von der modulierenden Spannung aufgrund einer thermisch bedingten Frequenzübertragungsfunktion des Senders für die Modulationsfrequenz der modulierenden Spannung verzerrt wird, wobei zur Erzeugung des verzerrungsfreien frequenzmodulierten optischen Signals die modulierende Spannung und/oder das verzerrte frequenzmodulierte optische Signal selbst und/oder ein dieses optische Signal enthaltendes Überlagerungssignal einer die Verzerrung dieses optischen Signals ganz oder teilweise kompensierenden Verzerrung unterworfen wird. Dieses Verfahren ist einfach und vermeidet in Verbindung mit Empfängern für das frequenzmodulierte optische Signal Empfindlichkeitsverluste.

FIG 1

EP 0 582 275 A1

Die Erfindung betrifft ein Verfahren zur Erzeugung eines verzerrungsfreien frequenzmodulierten optischen Signals und Einrichtungen zur Durchführung eines solchen Verfahrens.

Beim optischen Überlagerungsempfang wird dem von einem optischen Sendelaser erzeugten modulierten optischen Signal in Form des modulierten Lichts dieses Sendelasers im Empfänger ein optisches Referenzsignal einer bestimmten Referenzfrequenz in Form des unmodulierten Lichts eines lokalen Oszillatorlasers zugesetzt. Gegenüber dem bekannten Direktempfang erhält man beim Überlagerungsempfang gleichzeitig eine höhere Empfindlichkeit und höhere Trennschärfe zur Auswahl mehrerer angebotener Sendekanäle.

Als besonders aussichtsreiches Modulationsverfahren hat sich binäre Frequenzumtastung (FSK, frequency shift keying) herausgestellt, da sich die als Signalsender verwendeten Halbleiterlaser durch Änderung des Stroms einfach frequenzmodulierten lassen. Idealerweise sollte der erzielte Frequenzhub von der Modulationsfrequenz unabhängig sein. Das ist aber normalerweise nicht der Fall. Insbesondere lassen sich Sequenzen, die aus vielen gleichen Symbolen bestehen, nicht verzerrungsfrei übertragen. Oft läßt sich die Bitfehlerrate trotz hoher Empfangsleistung nicht unter den Wert $10^{-5}$ drücken (bit error rate floor).

Als Abhilfe sind bekannt:
- Manchesterkodierung (siehe R. Noé et al, Electronics Letters 25 (1989) 12, S. 757-758), die sich wegen Verdoppelung der Schrittgeschwindigkeit nicht für hohe Bitraten eignet. Ähnliches gilt für Subträgerverfahren.
- Alternate-Mark-Inversion- oder AMI-Kodierung (siehe R. Noé et al, Journal of Optical Communications 10 (1989) 3, S. 82- 84), die eine gegenüber normaler Frequenzumtastung geringere Empfindlichkeit ergibt.
- Bipolare Kodierung (siehe R.S. Vodhanel, B.Enning, Electronics Letters 24 (1988) 3, S. 163-165, für die ähnliches wie für die AMI-Kodierung gilt.
- Quantisierte Rückkopplung vom Entscheider zum Basisbandsignal (siehe B. Enning, R. S. Vodhanel, Electronics Letters 24 (1988) 7, S. 397-399). Bei dieser quantisierten Rückkopplung dürfen Kennfrequenzwerte der Frequenzumtastung nicht in Maxima eines Ausgangssignals eines Frequenzdiskriminators liegen, sondern müssen dazwischenliegen, damit sie Modulationsverzerrungen ausgleichen kann. Es ist aber bekannt, daß, wenn man die Kennfrequenzwerte nicht in die Maxima sondern dazwischenlegt, sich eine suboptimale reduzierte Empfängerempfindlichkeit ergibt.

Der im Anspruch 1 angegebenen Erfindung liegt die Aufgabe zugrunde, ein für Halbleiterlaser als Signalssender geeignetes einfaches Verfahren zur Erzeugung eines verzerrungsfreien frequenzmodulierten optischen Signals anzugeben, bei welchem Empfindlichkeitsverluste vermieden werden.

Gemäß der Erfindung werden oder wird zur Entzerrung des durch den thermischen Tiefpaßanteil des Halbleiterlasers verzerrten frequenzmodulierten optischen Signals, die den Halbleiterlaser ansteuernde modulierende Spannung und/oder das verzerrte frequenzmodulierende optische Signal selbst und/oder die in einem Überlagerungssignal aus dem frequenzmodulierten optischen Signal und einem optischen Referenzsignal enthaltene Verzerrung einer die thermisch bedingte Verzerrung kompensierenden Verzerrung unterworfen.

Vorzugsweise wird ein Halbleiterlaser gemäß Anspruch 2 verwendet.

Zwei mit einem derartigen Halbleiterlaser arbeitende alternative Verfahren, bei denen die modulierende Spannung zur Entzerrung verzerrt wird und die auch in Kombination mit Verfahren verwendet werden können, bei denen das frequenzmodulierte optische Signal selbst zur Entzerrung verzerrt wird, sind in den Ansprüchen 3 und 4 angegeben. Bei diesen Verfahren kann mit passiven Entzerrern gearbeitet werden.

Ferner ist es vorteilhaft, einen Halbleiterlaser gemäß Anspruch 5 zu verwenden. Ein mit einem solchen Laser arbeitendes vorteilhaftes Verfahren, bei welchem ebenfalls die modulierende Spannung zur Entzerrung verzerrt wird, ist im Anspruch 6 angegeben. Bei diesem Verfahren kann mit Hoch- und Tiefpaßfiltern gearbeitet werden.

Insbesondere bei dem Verfahren nach Anspruch 6 ist es vorteilhaft, gemäß Anspruch 7 einen TTG-Laser als Halbleiterlaser zu verwenden.

Generell ist es von vorteil, einen Halbleiterlaser zu verwenden, wie er im Anspruch 8 definiert ist. Ein solcher Laser ist für alle drei erfindungsgemäßen Arten der Entzerrung vorteilhaft.

Ein bevorzugter Halbleiterlaser nach Anspruch 8 ist im Anspruch 9 definiert.

In den Ansprüchen 10 bis 13 sind alternative bevorzugte und vorteilhafte Ausgestaltungen des erfindungsgemäßen Verfahrens angegeben, bei denen jeweils die Verzerrung des frequenzmodulierten optischen Signals durch Manipulation an diesem Signal selbst oder an einer Referenzfrequenz eines mit diesem Signal überlagerten Referenzsignals entzerrt wird. Diese Ausgestaltungen sind in Kombination miteinander und/oder in Kombination mit Verfahren, bei denen das Modulationssignal zur Entzerrung verzerrt wird, beispielsweise mit einem Verfahren nach einem der Ansprüche 3 bis 7 anwendbar.

Die in Anspruch 13 angegebene bevorzugte und vorteilhafte Ausgestaltung des erfindungsgemäßen Verfahrens entspricht einer Kombination der alternativen Ausgestaltungen nach den Ansprüchen 11 und 12.

Anspruch 14 gibt eine bevorzugte und vorteilhafte Ausgestaltung des erfindungsgemäßen Verfahrens an, bei welchem zur Entzerrung sowohl die modulierende Spannung als auch das frequenzmodulierende optische Signal verzerrt wird, wobei das frequenzmodulierende optische Signal mit Hilfe einer Änderung einer Referenzfrequenz eines Referenzsignals verzerrt wird, das dem frequenzmodulierten optischen Signal überlagert ist.

Eine Einrichtung zur Durchführung eines Verfahrens nach Anspruch 6 oder 7 ist im Anspruch 15 angegeben. Die Ansprüche 16 bis 23 geben bevorzugte und vorteilhafte Ausgestaltungen der Einrichtung nach Anspruch 15 an.

Anspruch 24 ist auf eine Einrichtung zur Durchführung eines Verfahrens nach Anspruch 11 gerichtet, wobei die Ansprüche 25 und 26 bevorzugte und vorteilhafte Ausgestaltungen dieser Einrichtung nach Anspruch 24 angeben.

Anspruch 27 ist auf eine Einrichtung zur Durchführung eines Verfahrens nach Anspruch 12 oder 13 gerichtet.

Anspruch 28 ist auf eine Einrichtung zur Durchführung eines Verfahrens nach Anspruch 8 gerichtet.

Anspruch 29 ist auf eine Einrichtung zur Durchführung eines Verfahrens nach Anspruch 14 gerichtet.

Anspruch 30 ist auf eine Einrichtung zur Durchführung eines Verfahrens nach Anspruch 10 gerichtet.

Die Erfindung wird anhand der Figuren in der nachfolgenden Beschreibung näher erläutert, aus der sich auch die Vorteile der Erfindung deutlich ergeben. Es zeigen:

Figur 1
in schematischer Darstellung ein Ausführungsbeispiel einer erfindungsgemäßen Einrichtung zur Entzerrung des thermisch bedingt verzerrten freqenzmodulierten optischen Signals durch Verzerrung der modulierenden Spannung mittels Filtern in Form von passiven Entzerrern,

Figur 2
in einem Diagramm beispielhaft und qualitativ den Betrag $|\delta f/\delta u_M|$ der Modulationssteilheit $\delta f/\delta u_M$ für die Pumpelektrode und die weitere Elektrode des Lasers in Abhängigkeit von der Modulationsfrequenz $f_m$,

Figur 3a
in einem Diagramm über der Zeit t ein typisches zeitliches Verhalten der Signalfrequenz $f_s$ eines vom Halbleiterlaser abgegebenen frequenzmodulierten binären optischen Signals für den Fall, daß zwischen zwei Bitmustern mit wechselnden Binärwerten eine längere Bitfolge nur eines Binärwertes auftritt,

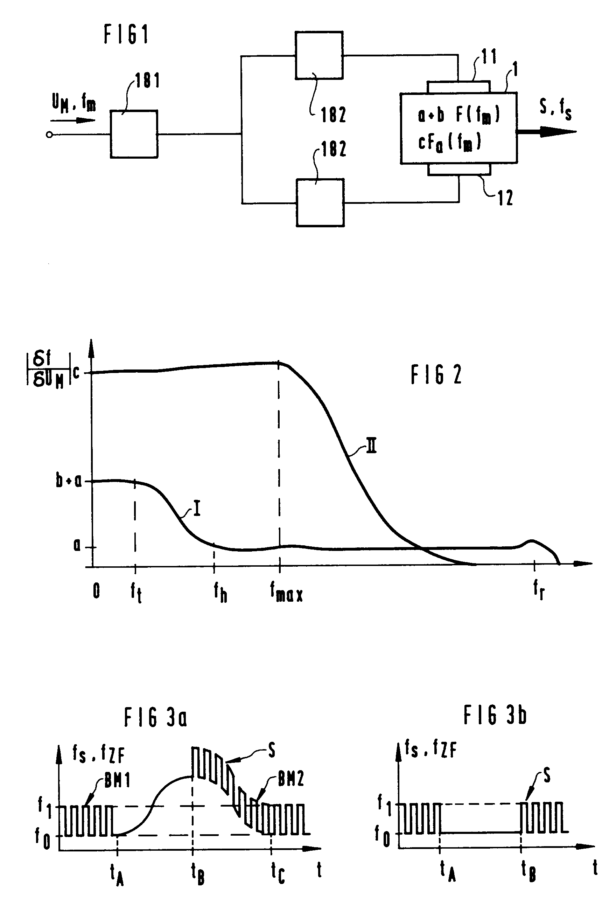

Figur 3b
in einem Diagramm über der Zeit t das gewünschte Idealverhalten des in Figur 2a angenommenen frequenzmodulierten optischen Signals, das erreicht werden soll,

Figur 4
in schematischer Darstellung ein Ausführungsbeispiel einer erfindungsgemäßen Einrichtung zur Entzerrung des thermisch bedingt verzerrten frequenzmodulierten optischen Signals durch Verzerrung der modulierenden Spannung mittels Hoch- und Tiefpaßfilter,

Figur 5a
bis 5c jeweils einen Ausschnitt aus der Figur 1, der eine Änderung des Ausführungsbeispiels nach Figur 1 zeigt,

Figuren 6a und 6b
jeweils eine konkrete Realisierung einer Hochpaßfiltereinrichtung und einer Tiefpaßfiltereinrichtung des Ausführungsbeispiels nach Figur 1,

Figur 6c
eine andere konkrete Realisierung der Hochpaß- und Tiefpaßfiltereinrichtung des Ausführungsbeispiels nach Figur 1,

Figur 7
in schematischer Darstellung ein erstes Ausführungsbeispiel einer Einrichtung zur Entzerrung des thermisch bedingt verzerrten frequenzmodulierten optischen Signals durch Verzerrung des frequenzmodulierten optischen Signals selbst mit Hilfe eines diesem Signal überlagerten Referenzsignals,

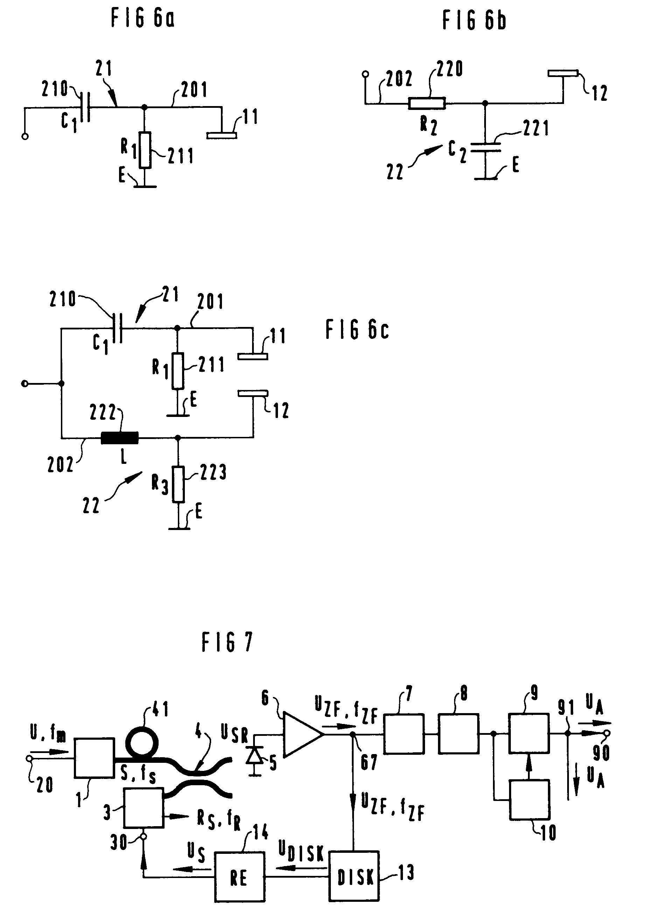

Figur 8
eine Ausgangsspannung eines beim Ausführungsbeispiel nach Figur 7 verwendeten Frequenzdiskriminators für ein aus dem frequenzmodulierten optischen Signal durch Überlagerung mit dem Referenzsignal erzeugtes Zwischenfrequenzsignal in Abhängigkeit von der Zwischenfrequenz des Zwischenfrequenzsignals,

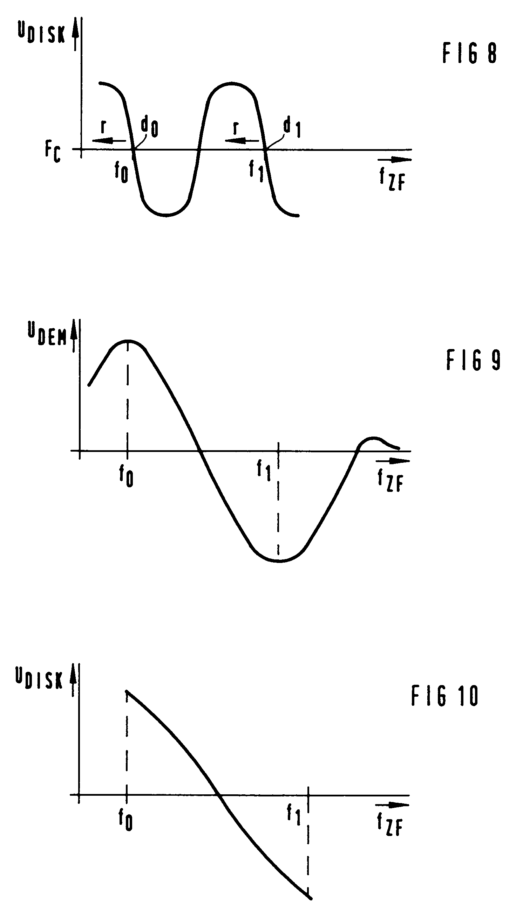

Figur 9
zum Vergleich mit der Charakteristik des Frequenzdiskriminators nach Figur 8 eine Ausgangsspannung eines zur Demodulation eines aus dem frequenzmodulierten optischen Signal durch herkömmlichen Überlagerungsempfang gewonnenen Zwischenfrequenzsignals verwendeten Frequenzdiskriminators in Abhängigkeit von der Zwischenfrequenz dieses Zwischenfrequenzsignals,

Figur 10
zum Vergleich mit der Charakteristik des Frequenzdiskriminators nach den Figuren 8 und 9 eine Ausgangsspannung eines zur Demodulation eines aus dem frequenzmodulierten optischen Signal durch herkömmlichen Überlagerungsempfang gewonnenen Zwischenfrequenzsignals verwendeten anderen Frequenzdiskriminators in Abhängigkeit von der Zwischenfrequenz dieses Zwischenfrequenzsignals,

Figur 11

in schematischer Darstellung ein zweites Ausführungsbeispiel einer Einrichtung zur Entzerrung des thermisch bedingt verzerrten frequenzmodulierten optischen Signals durch Verzerrung des frequenzmodulierten optischen Signals selbst mit Hilfe eines diesem Signal überlagerten Referenzsignals,

Figur 12

in schematischer Darstellung ein drittes Ausführungsbeispiel einer Einrichtung zur Entzerrung des verzerrten frequenzmodulierten optischen Signals, das einer Kombination aus dem Ausführungsbeispiel nach den Figuren 7 und 10 entspricht, und

Figur 13

in schematischer Darstellung ein Ausführungsbeispiel einer Einrichtung zur Entzerrung des thermisch bedingt verzerrten frequenzmodulierten optischen Signals durch Verzerrung sowohl des Modulationssignals als auch des frequenzmodulierten Signals selbst, und

Figur 14

in schematischer Darstellung ein weiteres Ausführungsbeispiel einer Einrichtung zur Entzerrung des thermisch bedingt verzerrten frequenzmodulierten optischen Signals durch Verzerrrung des frequenzmodulierten Signals, wobei zur Entzerrung ein Frequenzkonverter verwendet ist.

In den Figuren sind zur besseren Unterscheidung elektrischer Signalwege oder Leitungen von optischen Signalwegen oder Leitungen die optischen Signalwege und Leitungen fett dargestellt.

In den Figuren sind, soweit dargestellt, der Halbleiterlaser mit 1, die Pumpelektrode mit 11 und die weitere Elektrode mit 12 bezeichnet. Der Laser 1 wird durch die an die Elektrode 11 anzulegende modulierende elektrische Spannung $u_M$ der Modulationsfrequenz $f_m$ gepumpt und gibt ein von der modulierenden Spannung $u_M$ abhängiges frequenzmoduliertes optisches Signal S einer modulierten Signalfrequenz $f_s$ ab.

Wird an die Pumpelektrode 11 die modulierende Spannung $u_M$ direkt angelegt, so ist das vom Laser 1 abgegebene frequenzmodulierte optische Signal S in Form der vom Laser 1 abgestrahlten Laserstrahlung gegenüber der ansteuernden modulierenden Spannung $u_M$ verzerrt. Dies hat seinen Grund darin, daß die Modulationssteilheit $\delta f/\delta u_M$, die gegeben ist durch das von der Modulationsfrequenz $f_m$ abhängige Verhältnis zwischen einer Änderung $\delta f$ der Signalfrequenz $f_s$ des frequenzmodulierten optischen Signals S und einer Änderung $\delta u_M$ der an die Pumpelektrode 11 anzulegenden modulierenden Spannung $u_M$, zumindest in erster Näherung eine lineare Funktion $a + bF(f_m)$ des thermischen Tiefpaßanteils $F(f_m)$ der Frequenzübertragungsfunktion des Halbleiterlasers 1 ist, wobei a eine additive Konstante und b einen Proportionalitätsfaktor des thermischen Tiefpaßanteils $F(f_m)$ bedeuten. a und b sind im allgemeinen komplexe Zahlen, die auch Werte auf der reellen Zahlenachse annehmen können, bei denen der Imaginärteil null ist. Es genügt, im folgenden nur solche Werte in Betracht zu ziehen.

Eine Erklärung dieses Phänomens kann wie folgt gegeben werden, wobei zur einfacheren Darstellung beispielhaft, aber ohne Beschränkung der Allgemeinheit angenommen wird, daß die Modulationsspannung $u_M$ im Laser 1 einen Modulationsstrom $i_M = u_M/50$ Ohm erzeugt.

Vergrößert man allgemein den Pumpstrom eines Halbleiterlasers so vergrößert sich die Trägerdichte in der aktiven Zone dieses Lasers und somit der Brechungsindex des Lasers. Dies führt zu einer Frequenzänderung in der vom Laser abgestrahlten Laserstrahlung um einen Wert der additiven Konstante a von beispielsweise etwa (50 bis 300 MHz/mA)/50 Ohm. Änderungen dieser Charakteristik in der Nähe der Laserrelaxationsfrequenz sind für die vorliegende Erfindung nicht von Bedeutung.

Durch die Stromerhöhung vergrößert sich aber auch die Verlustleistung des Lasers, wodurch sich allmählich die Temperatur erhöht. Dadurch ändert sich auch die Frequenz der abgestrahlten Laserstrahlung. Nach Erreichen der Endtemperatur hat sie sich um etwa einen Wert des Proportionalitätsfaktors b verändert, der (-1000 MHz/mA)/50 Ohm beträgt. Für die Modulationssteilheit $\delta f/\delta u_M$ gilt dann, wie bereits erwähnt:

$$\delta f/\delta u_M = a + bF(f_m),$$

wobei überdies für die signalsenderbedingte Tiefpaßübertragungsfunktion $F(f_m)$ gilt, daß sie für tiefe Modulationsfrequenzen $f_m$ der modulierenden Spannung $u_M$, die kleiner als eine bestimmte, zwischen einer kleinsten ersten Frequenz 0 und einer bestimmten zweiten Frequenz $f_r$ (Relaxationsfrequenz des Lasers) liegenden dritten Frequenz $f_t$ sind, im wesentlichen den Wert 1 und für hohe Modulationsfrequenzen $f_m$, die größer als eine im Vergleich zur dritten Frequenz $f_t$ größere bestimmte vierte Frequenz $f_h$ sind, zumindest im wesentlichen den Wert 0 annimmt. Beispielsweise unterscheide sich die thermisch bedingte Tiefpaßübertragungsfunktion $F(f_m)$ für vierte Frequenzen $f_h$ von etwa 100 kHz bis etwa 10 MHz nicht mehr wesentlich von 0.

In Figur 2 zeigt Kurve I qualitativ den Betrag $|\delta f/\delta u_M|$ der Modulationssteilheit $\delta f/\delta u_M$ bezogen auf die Pumpelektrode 11 und Kurve II qualitativ diesen Betrag $|\delta f/\delta u_M|$ bezogen auf die weitere Elektrode 12 eines beispielhaften Halbleiterlasers 1 in Abhängigkeit von der Modulationsfrequenz $f_m$.

Die Kurve I verläuft zwischen der ersten Frequenz 0 und der dritten Frequenz $f_t$ flach und hat dort etwa den Wert a + b. Im Bereich zwischen der dritten Frequenz $f_t$ und der vierten Frequenz $f_h$ fällt sie auf etwa den Wert a ab und verläuft zwischen der vierten Frequenz $f_h$ und der vergleichsweise viel größeren zweiten Frequenz $f_r$ wieder flach.

Die Kurve II verläuft zwischen der ersten Frequenz 0 und der im Vergleich zur vierten Frequenz $f_h$ größeren fünften Frequenz $f_{max}$ flach und hat dort etwa den Wert der auf die weitere Elektrode 12 bezogenen Porportionalitätskonstanten c. Im Bereich zwischen der fünften Frequenz $f_{max}$ und der größeren zweiten Frequenz $f_r$ fällt sie im wesentlichen auf den Wert null ab.

Da $f_{max} > f_h$ ist, gibt es zwei sich überlappende Bereiche mit flachem Verlauf oder Frequenzgang. Einer dieser Bereiche liegt zwischen 0 und $f_t$, der andere zwischen $f_h$ und $f_{max}$.

Diese beiden Überlappungsbereiche kann man kombinieren durch:

1) Modulation sowohl der Pumpelektrode 11 als auch der weiteren Elekrode 12 des Halbleiterlasers 1 und

2) Modulation der Pumpelektrode 11 des Lasers 1 und einer Elektrode eines Referenzsignalsenders, deren Frequenzgang von 0 bis $f_{max}$ flach ist.

Die Modulation nach 2) kann mit Hilfe eines Referenzsignalsenders über eine quantisierte Rückkopplung und/oder eine automatische Frequenzregelung, die Einfluß auf ein Zwischenfrequenzsignal ZF nimmt, oder mit Hilfe eines Frequenzkonverters, der Einfluß auf die Frequenz eines durch Frequenzkonversion des frequenzmodulierten optischen Signals gewonnenen optischen Signals nimmt, vorgenommen werden.

Für Werte a + b > 0 bei positivem Wert a und Werte a + b < 0 bei negativem a läßt sich die Tiefpaßübertragungsfunktion $F(f_m)$ mit einem einfachen passiven Entzerrer, der zum Beispiel aus Widerständen und Kondensatoren gebildet sein kann, so kompensieren, daß die Modulationssteilheit $\delta f/\delta u_M$ eine von der Modulationsfrequenz $f_m$ unabhängige Konstante ist. Dies ist jedoch im allgemeinen nicht der Fall.

Die Figur 3a zeigt ein typisches zeitliches Verhalten der Signalfrequenz $f_s$ eines vom Signalsender 1 abgegebenen binären frequenzmodulierten optischen Signals S für den Fall, daß zwischen zwei Binärmustern BM1, BM2 mit verschiedenen, beispielsweise abwechselnden Binärwerten eine längere Bitfolge nur eines Binärwertes auftritt. Dabei sei angenommen, daß ein Binärwert durch die Frequenz $f_0$ und der andere durch eine davon verschiedene Frequenz $f_1$ des Signals S definiert ist. Die längere Bitfolge nur des einen Binärwertes, beispielsweise des Binärwertes der Frequenz $f_0$, beginne nach dem Bitmuster BM1 zum Zeitpunkt $t_A$ und ende mit Beginn des nächsten Bitmusters BM2 zum Zeitpunkt $t_B$.

Wie der Figur 3a zu entnehmen ist, bleibt die Signalfrequenz $f_s$ nach dem Zeitpunkt $t_A$ nicht bei der Frequenz des nur einen Binärwertes der längeren Bitfolge, im Beispiel also bei der Frequenz $f_0$, sondern ändert sich zeitlich. Erst ab dem Einsetzen des nächsten Bitmusters BM2 zum Zeitpunkt $t_B$ gehen die den beiden Binärwerten entsprechenden geänderten Frequenzen allmählich wieder auf ihre ursprünglichen Werte $f_0$ und $f_1$ zurück, die etwa beim Zeitpunkt $t_C$ erreicht werden.

Die Figur 3b zeigt dagegen das gewünschte Idealverhalten des in Figur 2a angenommenen frequenzmodulierten optischen Signals S, das je nach den Umständen mehr oder weniger erreicht werden soll. Die Signalfrequenz $f_s$ nach der Figur 2b bleibt auch während der längeren Bitfolge des nur einen Binärwertes konstant auf der diesem Binärwert entsprechenden Frequenz, im Beispiel der Frequenz $f_0$. Unter "verzerrungsfreien frequenzmodulierendes Signal" im vorstehenden und im Anspruch 1 ist jedes frequenzmodulierende Signal S zu verstehen, das gegenüber einem vom Signalsender 1 verzerrt erzeugten Signal S, beispielsweise dem Signal S nach Figur 2a, in Richtung zum unverzerrten Signal S des Idealfalls verbessert ist oder diesen Idealfall erreicht.

Das Idealverhalten des frequenzmodulierten optischen Signals S wird erfindungsgemäß durch eine Entzerrung dieses Signals S mittels einer Verzerrung der modulierenden Spannung $u_M$ und/oder einer Verzerrung des vom Halbleiterlaser 1 frequenzmodulierten optischen Signals S ganz oder zumindest angenähert erreicht.

Beim Ausführungsbeispiel nach Figur 1 wird das frequenzmodulierte optische Signal S durch Verzerrung der modulierenden Spannung $u_M$ mittels passiven Entzerrern entzerrt, wobei entweder a + b>0 und a>0 oder a + b<0 und a<0 vorausgesetzt ist.

Bei diesem Ausführungsbeispiel wird sowohl die der Pumpelektrode 11 als auch die der weiteren Elektrode 12 zuzuführende modulierende Spannung $u_M$ mit Entzerrern 181, 182 und 183, die auch dämpfen können, derart verzerrt, daß die Verzerrung des frequenzmodulierten optischen Signals S ganz oder teilweise kompensiert wird, d.h. daß die Modulationssteilheit $\delta f/\delta u_M$ zumindest annähernd konstant wird.

Im Beispiel nach Figur 1 sind drei Entzerrer 181, 182 und 183 vorgesehen, von denen der vorgeschaltete Entzerrer 181 der Pumpelektrode 11 und der weiteren Elektrode 12 gemeinsam zugeordnet ist, während der Entzerrer 182 nur der Pumpelektrode 11 und der Entzerrer 183 nur der weiteren Elektrode 12 zugeordnet ist. Im allgemeinen kann entweder der Entzerrer 181 oder der Entzerrer 182 fortgelassen werden.

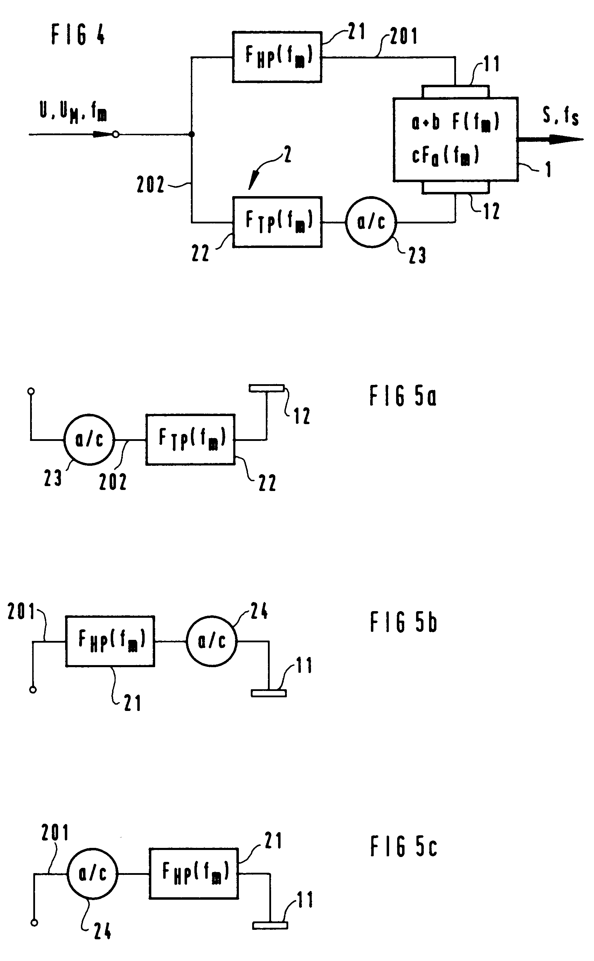

Beim Ausführungsbeispiel nach Figur 4 ist ein Halbleiterlaser 1 verwendet, dessen thermische Tiefpaßübertragungsfunktion $F(f_m)$, wie schon erwähnt, für tiefe Modulationsfrequenzen $f_m$ des frequenzmodulierten optischen Signals S , die kleiner als die bestimmte dritte Frequenz $f_t$ sind, im wesentlichen den Wert 1 und für hohe Modulationsfrequenzen $f_m$, die größer als die im Vergleich zur dritten Frequenz $f_t$ größere bestimmte vierte Frequenz $f_h$ sind, zumindest im wesentlichen den Wert 0 annimmt.

Die weitere Elektrode 12 dieses Halbleiterlasers 1 ist so angeordnet und/oder so ausgebildet, daß bei einem Anlegen der modulierenden Spannung $u_M$ an die weitere Elektrode 12 die auf diese weitere Elektrode bezogene Modulationssteilheit $\delta f/\delta u_M$ zumindest angenähert

$$\delta f/\delta u_M = cF_a(f_m)$$

ist, wobei c die bestimmte auf die weitere Elektrode 12 bezogene Proportionalitätskonstante und $F_a(f_m)$ eine weitere, auf diese Elektrode bezogene laserbedingte Tiefpaßübertragungsfunktion für die Modulationsfrequenz $f_m$ bedeuten, und wobei die weitere laserbedingte Tiefpaßübertragungsfunktion $F_a(f_m)$ für Modulationsfrequenzen $f_m$, die kleiner oder gleich sind der fünften Frequenz $f_{max}$, die größer als die vierte Frequenz $f_h$ ist, im wesentlichen den Wert 1 annimmt, so daß sich für $|\delta f/\delta u_M|$ qualitativ die Kurve II nach Figur 2 ergibt.

Diese Eigenschaften treffen auf Halbleiterlaser 1 zu, die neben der Elektrode zum Pumpen noch mindestens eine weitere Elektrode 12 in Form einer Abstimmelektrode aufweisen. Die Proportionalitätskonstante c hat für solche Laser einen Wert von ungefähr (-100 bis +100 GHz/mA)/50 Ohm. Gleichzeitig ist normalerweise $f_{max}$ kleiner als die halbe Bitrate des Modulationssignals U, so daß eine direkte Modulation über die Abstimmelektrode nicht ausreichend ist. Für TTG-Laser (siehe K. Drögemüller, S. Illek, Proc. ECOC 90, Amsterdam, Niederlande, S. 181-184) ist die Proportionalitätskonstante c etwa 3 bis 10 GHz/mA/50 Ohm und $f_{max}$ größer als 100 MHz.

Nach Figur 4 ist eine Hochpaßfiltereinrichtung 21 zum Hochpaßfiltern der der Pumpelektrode 11 zugeführten modulierenden Spannung $u_m$ und eine Tiefpaßfiltereinrichtung 22 zum Tiefpaßfiltern der der weiteren Elektrode 12 zugeführten modulierenden Spannung $U_m$ vorgesehen, wobei die Tiefpaßfiltereinrichtung 22 eine vorbestimmte Tiefpaßübertragungsfunktion $F_{TP}(f_m)$ für die Modulationsfrequenz $f_m$ des frequenzmodulierten optischen Signals S aufweist, die für Modulationsfrequenzen $f_m$, die sehr klein gegenüber einer zwischen der vierten Frequenz $f_h$ und der fünften Frequenz $f_{max}$ liegenden bestimmten sechsten Frequenz $f_g$ sind, im wesentlichen den Wert 1 annimmt, und wobei die Hochpaßübertragungsfunktion $F_{HP}(f_m)$ der Hochpaßfiltereinrichtung 21 gleich $1-F_{TP}(f_m)$ ist und diese Hochpaßübertragungsfunktion $F_{HP}(f_m)$ für Modulationsfrequenzen $f_m$, die groß gegenüber der sechsten Frequenz $f_g$ sind, zumindest im wesentlichen den Wert 1 annimmt.

Überdies ist es zweckmäßig, wenn der Tiefpaßfiltereinrichung 22 eine Multipliziereinrichtung 23 zum Multiplizieren der ungefilterten oder durch diese Tiefpaßfiltereinrichtung 22 gefilterten modulierenden Spannung $u_M$ mit dem Faktor a/c vor- oder nachgeschaltet ist, wobei c die bestimmte Proportionalitätskonstante und a die additive Konstante der linearen Funktion $a+bF(f_m)$ ist. Beim Ausführungsbeispiel nach Figur 4 ist die Multipliziereinrichtung 23 der Tiefpaßfiltereinrichtung 22 nachgeschaltet. Die Figur 5a zeigt den Fall, bei dem die Multipliziereinrichtung 23 der Tiefpaßfiltereinrichtung 22 vorgeschaltet ist.

Alternativ dazu kann der Hochpaßfiltereinrichtung 21 eine Multipliziereinrichtung 24 zum Multiplizieren der ungefilterten oder durch die Hochpaßfiltereinrichtung 21 gefilterten modulierenden Spannung $u_M$ mit dem Faktor c/a vor- oder nachgeschaltet sein. Die Figur 5b zeigt den Fall, bei dem die Multipliziereinrichtung 24 der Hochpaßfiltereinrichtung 21 nachgeschaltet ist und Figur 5c zeigt den Fall, bei dem die Multipliziereinrichtung 24 der Hochpaßfiltereinrichtung 21 vorgeschaltet ist.

Darüberhinaus ist es zweckmäßig, wenn die Signallaufzeit in dem Signalpfad 201, in dem die Hochpaßfiltereinrichtung 21 angeordnet ist und der zur Elektrode 11 zum Pumpen des Halbleiterlasers 1 führt, gleich der Signallaufzeit im Signalpfad 202 ist, in welchem die Tiefpaßfiltereinrichtung 220 angeordnet ist und der zur weiteren Elektrode 12 des Halbleiterlasers 1 führt. Dies kann, falls erforderlich, durch Einfügen eines oder mehrerer Verzögerungsglieder in den Signalpfad 201 und/oder den Signalpfad 202 bewirkt werden.

Es läßt sich zeigen, daß für die Ausführungsformen nach den Figuren 4 und 5a sowie nach den Figuren 5b und 5c unter den oben angegebenen Bedingungen für die Übertragungsfunktionen $F(f_m)$, $F_a(f_m)$, $F_{HP}(f_m)$ und $F_{TP}(f_m)$ die Gesamtmodulationssteilheit $\delta f/\delta u_M$, bei der alle diese Übertragungsfunktionen und im Fall der Figuren 4 und 5a der Faktor a/c und im Fall der Figuren 5b und 5c der Faktor c/a berücksichtigt sind, im wesentlichen gleich

$$\delta f/\delta u_M = au_M(f_m)$$

ist, d.h. daß diese Gesamtmodulationssteilheit $\delta f/u_m$

tatsächlich im wesentlichen unabhängig von der Modulationsfrequenz $f_m$ ist und daß damit keine Verzerrungen des optischen frequenzmodulierten Signals S gegenüber der modulierenden Spannung auftreten.

Das Verfahren und die Einrichtungen, bei denen die modulierende Spannung zur Entzerrung des frequenzmodulierten optischen Signals verzerrt wird, haben generell den Vorteil, daß sie für beliebige frequenzmodulierte optische Nachrichtenübertragungsanwendungen geeignet sind, beispielsweise sowohl für optische Überlagerungsempfänger wie Homodyn- und Heterodynempfänger, als auch für andere Empfangsverfahren, beispielsweise für Direktempfang mit optischem Frequenzdiskriminator. Außerdem besteht generell der Vorteil, daß beliebige Empfänger verwendet werden können, da die Frequenzmodulation zumindest angenähert in idealer Weise erfolgt. Diese Vorteile gelten insbesondere für die in den Figuren 3, 4a bis 4c dargestellten Ausführungsbeispiele der Erfindung.

Die in Figur 6a gezeigte Realisierung einer Hochpaßfiltereinrichtung 21 weist eine in dem zur Pumpelektrode 11 des Halbleiterlasers 1 führenden Signalpfad 201 für die modulierende Spannung $u_M$ geschaltete Kapazität 210 mit einem Kapazitätswert $C_1$ und einen zwischen diesen Signalpfad 201 und ein Bezugspotential E, beispielsweise Masse, geschalteten Widerstand 211 mit einem Widerstandswert $R_1$ auf. Der Kapazitätswert $C_1$ und der Widerstandswert $R_1$ sind so bemessen, daß gilt

$$f_g = 1/2\pi C_1 R_1,$$

wobei $f_g$ die obengenannte sechste Frequenz ist.

Die in Figur 6b gezeigte Realisierung einer Tiefpaßfiltereinrichtung 22 weist einen in den zur weiteren Elektrode 12 des Halbleiterlasers 1 führenden Signalpfad 202 für die modulierende Spannung $u_M$ geschalteten Widerstand 220 mit einem Widerstandswert $R_2$ und eine zwischen diesen Signalpfad 202 und ein Bezugspotential E, beispielsweise Masse, geschaltete Kapazität 221 mit einem Kapazitätswert $C_2$ auf Der Widerstandswert $R_2$ und der Kapazitätswert $C_2$ sind so bemessen, daß gilt

$$f_g = 1/2\pi C_2 R_2.$$

Bei der in Figur 6c gezeigten Realisierung einer Hochpaß- und Tiefpaßfiltereinrichtung besteht die Hochpaßfiltereinrichtung 21 aus der Einrichtung nach Figur 6a mit der Kapazität 210 und dem Widerstand 211. Die Tiefpaßfiltereinrichtung 22 besteht dagegen aus einer in den zur weiteren Elektrode 12 führenden Signalpfad 202 für die modulierende Spannung $u_M$ geschalteten Induktivität 222 mit einem Induktivitätswert L und einem zwischen diesen Signalpfad 202 und ein Bezugspotential E, beispielsweise Masse, geschalteten Widerstand 223 mit einem Widerstandswert $R_3$. Der Kapazitätswert $C_1$ der in den zur Pumpelektrode 11 des Halbleiterlasers 1 führenden Signalpfad 201 für die modulierende Spannung $u_M$ geschalteten Kapazität 210 und der Widerstandswert $R_1$ des zwischen diesen Signalpfad 201 und das Bezugspotential E geschalteten Widerstands 211 der Hochpaßfiltereinrichtung 21 sowie der Induktivitätswert L der Induktivität 222 und der Widerstandswert $R_3$ des Widerstandes 223 der Tiefpaßfiltereinrichtung 22 sind jeweils so gewählt, daß gilt

$$f_g = 1/2\pi R_1 C_1 = 1/(2\pi R_3/L).$$

Wählt man überdies $R_1 = R_3$ ergibt sich vorteilhafterweise ein von der Modulationsfrequenz $f_m$ unabhängiger Eingangswiderstand für die modulierende Spannung $u_M$.

Bei den in den Figuren 7 und 11 bis 14 dargestellten verschiedenen Ausführungsbeispielen einer Einrichtung zur Entzerrung des frequenzmodulierten optischen Signals S durch Manipulation an diesem Signal S selbst ist ein Halbleiterlaser 1 mit einem Eingang 20 zum Anlegen der modulierenden Spannung $u_M$ und der thermischen Übertragungsfunktion $F(f_m)$ sowie ein optischer Überlagerungsempfänger vorausgesetzt. Der Eingang 20 kann beispielsweise ein Anschluß der Pumpelektrode 11 des Halbleiterlasers 1 sein.

Das vom Halbleiterlaser 1 abgegebene frequenzmodulierte optische Signal S mit der frequenzmodulierten Signalfrequenz $f_s$ wird beispielsweise durch eine optische Faser 41 einer optischen Koppeleinrichtung 4 des Empfängers, beispielsweise einem optischen Richtkoppler zugeführt, in welcher dem frequenzmodulierten optischen Signal ein von einem optischen Referenzsignalsender 3, beispielsweise einem Lokaloszillator des Empfängers, ein optisches Referenzsignal RS einer bestimmten Referenzfrequenz $f_R$ überlagert wird, so daß die beiden einander überlagerten Signale ein Zwischenfrequenzsignal ZF der Zwischenfrequenz $f_{ZF}$ = $f_s$- $f_R$ bilden, wobei sich dieses Zwischenfrequenzsignal ZF unter den Voraussetzungen der Figuren 2a und 2b zeitlich genauso verhält, wie das frequenzmodulierende optische Signal $f_s$ selbst, so daß diese beiden Figuren 2a und 2b auch für die Zwischenfrequenz $f_{ZF}$ gelten.

Das Zwischenfrequenzsignal ZF wird einem Photodetektor 5 des Empfängers zugeleitet und von diesem in ein elektrisches Signal umgewandelt, das in einem elektrischen Verstärker 6 des Empfängers verstärkt wird und an einem Ausgang dieses Verstärkers 6 zu einer Weiterverarbeitung in ein Ausgangssignal $U_A$ des Empfängers verfügbar ist.

Bei dem ersten Ausführungsbeispiel nach Figur 7 ist diese Weiterverarbeitung des elektrischen Zwischenfrequenzsignals ZF aus dem elektrischen Verstärker 6 nicht von Bedeutung. Bei diesem Ausführungsbeispiel kommt es nur darauf an, daß das elektrische Zwischenfrequenzsignal ZF der Zwischenfrequenz $f_{ZF} = f_s-f_R$ einem bestimmten Frequenzdiskriminator 13 zum Erzeugen eines von der Zwischenfrequenz $f_{ZF}$ abhängigen Amplitudensignalas $U_{DISK}$ aus dem Zwischenfrequenzsignal ZF zuführbar ist. Bei dem Ausführungsbeispiel nach Figur 7 sei dazu das Zwischenfrequenzsignal ZF an einem Punkt hinter dem Verstärker 6 abgezweigt.

Der Frequenzdiskriminator 13 ist so ausgebildet, daß sich das von ihm erzeugte Amplitudensignal $U_{DISK}$, beispielsweise eine Ausgangsspannung des Frequenzdiskriminators 13 als Funktion der Zwischenfrequenz $f_{ZF}$ des Zwischenfrequenzsignals ZF so verhält , wie es in der Figur 8 dargestellt ist. Danach weist dieses Amplitudensignal $U_{DISK}$ in Bezug auf einen bestimmten Amplitudenpegel $P_0$, vorzugsweise ein Nullpegel, zwei in einer gleichen Richtung r geneigte Pegeldurchgange $d_1$ und $d_2$ bei zwei verschiedenen Kennfrequenzwerten $f_0$ und $f_1$ der Zwischenfrequenz $f_{ZF}$ auf. Im Idealfall nach Figur 3b, bei dem das vom Halbleiterlaser 1 abgegebene frequenzmodulierte optische Signal S gegenüber der modulierenden Spannung $u_M$ unverzerrt ist, treten Zwischenfrequenzwerte auf, die gleich den Kennfrequenzwerten $f_0$, $f_1$ sind. Bei einer frequenzmäßigen Abweichung der Zwischenfrequenzwerte von den Kennfrequenzwerten $f_0$, $f_1$ werden die Zwischenfrequenzwerte mittels einer durch ein aus einem laufend ermittelten Amplitudenpegel P des Amplitudensignals $U_{DSIK}$ erzeugtes Ausgangssignal $U_S$ bewirkten Änderung der Referenzfrequenz $f_R$ des Referenzsignals RS wieder zumindest annähernd auf die Kennfrequenzwerte $f_0$, $f_1$ zurückgeregelt. Diesen beiden Kennfrequenzwerten $f_0$ und $f_1$ werden vorzugsweise die beiden Binärwerte eines binären Signals zugeordnet, d.h. dem Kennfrequenzwert $f_0$ entspricht ein Binärwert und dem Kennfrequenzwert $f_1$ der andere Binärwert des digitalen Signals.

Frequenzdiskriminatoren, die ein Amplitudensignal $U_{DISK}$ erzeugen, wie es in Figur 8 dargestellt ist, sind bekannt (siehe R. Noé et al: Electronics Letters 25 (1989)1, S.4-5 oder T. Imai, K. Iwashita: Proc. OOOC '89, Kobe, Japan Paper 18C2-6). Durch die beiden Pegeldurchgänge $d_0$ und $d_1$ ist es möglich, auch während langer Folgen nur eines Binärwertes die Zwischenfrequenz $f_{ZF}$ an die richtige Stelle anzubinden.

Das vom Frequenzdiskriminator 13 erzeugte Amplitudensignal $U_{DISK}$ wird einer Regeleinrichtung 14 zugeführt, die einen bei den Kennfrequenzwerten $f_0$ und $f_1$ liegenden, laufend ermittelten Amplitudenpegel P des Amplitudensignals $U_{DISK}$ als einen Istwert und den bestimmten Amplitudenpegel $P_0$ als einen Sollwert benutzt, und die ein von einer Abweichung dieses Istwertes P von diesem Sollwert $P_0$ abhängiges Ausgangssignal $U_S$ erzeugt, welches dem das Referenzsignal RS erzeugenden frquenzmodulierbaren optischen Referenzsignalsender als ein Steuersignal zu einer Änderung der Referenzfrequenz $f_R$ des Referenzsignals RS derart, daß die Abweichung des Istwertes P vom Sollwert $P_0$ zumindest annähernd rückgängig gemacht ist, zugeführt wird.

Ein besonderer Vorteil des ersten Ausführungsbeispiels nach den Figuren 7 und 8 liegt in der schnellen und automatischen Frequenzregelung. Außerdem genügt es, die Referenzfrequenz $f_R$ so nachzustimmen, daß die Zwischenfrequenz $f_{ZF}$ wenigstens näherungsweise den in Figur 3b gezeigten Idealverlauf annimmt. Als Regeleinrichtung kann typischerweise ein PI-Regler verwendet werden.

Es sei darauf hingewiesen, daß eine der Frequenzregelschleife nach Figur 7 ähnliche Regelschleife prinzipiell schon bekannt ist. Die bei dieser bekannten Regelschleife verwendeten Frequenzdiskriminatoren haben jedoch meist eine Charakteristik des Ausgangssignals $U_{DEM}$ als Funktion der Zwischenfrequenz $f_{ZF}$, wie sie aus der Figur 9 hervorgeht. Die beiden Binärwerte eines Binärsignals ergeben bei dieser Charakteristik gleich große Beiträge entgegengesetzten Vorzeichens, wobei die mittlere Zwischenfrequenz $f_{ZF}$ wie gewünscht, auf den Nulldurchgang $(f_0 + f_1)/2$ stabilisiert wird. Während einer langen Folge des Binärwertes würde demnach die zu diesem Binärwert gehörige Frequenz auf diesen Wert stabilisiert werden. Dabei wird aber auch das Ausgangssignal $U_{DEM}$ unbrauchbar weil gleich null. Deswegen wählte man bisher relativ niedrige Reglerverstärkungen, d.h. niedrige Reglerbandbreiten.

Während mit einer Charakteristik gemäß Figur 9 eine Stabilisierung der Zwischenfrequenz ZF nicht möglich ist, ergäbe sich andererseits mit einem Demodulator mit einer Characteristik des Ausgangssignals $U_{DISK}$ als Funktion der Zwischenfrequenz $f_{ZF}$, wie sie in Figur 10 dargestellt ist, eine suboptimale Empfängerempfindlichkeit.

Durch die erfindungsgemäß verwendeten, in der gleichen Richtung r geneigten Pegeldurchgange $d_0$ und $d_1$ bei den Kennfrequenzwerten $f_0$ und $f_1$ laßt sich die durch die Reglerverstärkung bestimmte Reglerbandbreite $f_B$ vorteilhafterweise und im Unterschied zum Stand der Technik drastisch erhöhen, wodurch ein Ausregeln der Frequenzschwankungen des Sendesignals S durch den Referenzsignalsender 3 ermöglicht wird. Dabei sollte die Frequenzmodulationscharakteristik des Referenzsignalsenders 3 für Modulationsfrequenzen im Bereich von $0 < f_m < f_{max}$ mit $f_{max} > f_B$ wenigstens

näherungsweise konstant sein. Die Ausregelung funktioniert dann vollständig, wenn $f_B > f_h$ ist. Da dies bei üblichen Halbleiterlasern nicht möglich ist, sollte daher beispielsweise ein abstimmbarer TTG-Laser als Referenzsignalsender 3 verwendet werden, wobei $f_{max}$ etwa 100 MHz betragen kann.

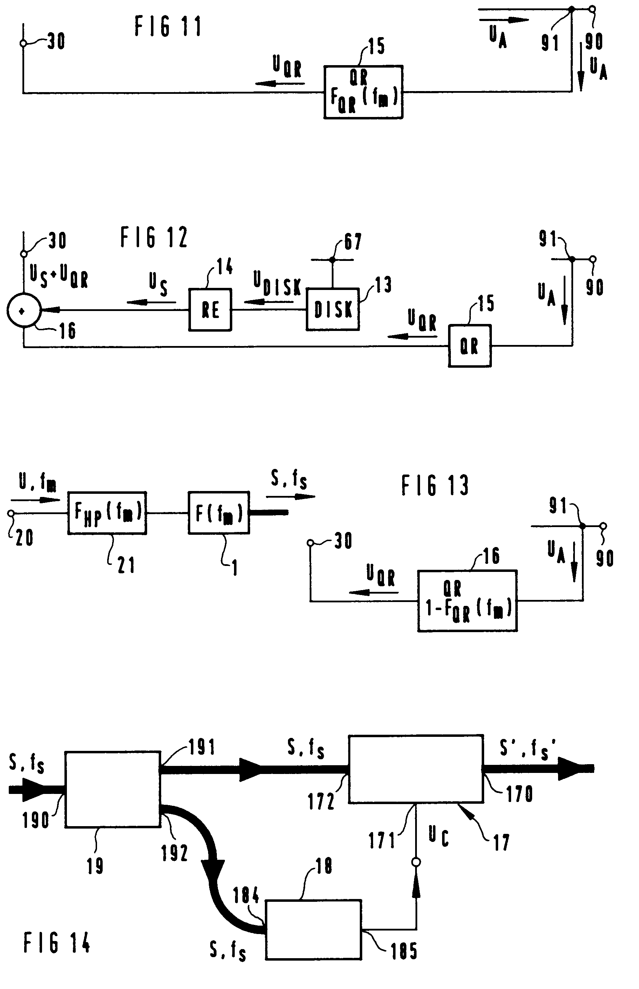

Bei dem Ausführungsbeispiel nach Figur 11 ist gegenüber dem Ausführungsbeispiel nach Figur 7 neben der Einrichtung 3 bis 6 zur Erzeugung des elektrischen Zwischenfrequenzsignals ZF noch die Einrichtung zur Erzeugung des der modulierenden Spannung $u_M$ zumindest annähernd entsprechenden und aus dem Zwischenfrequenzsignal ZF abgeleiteten Signals $u_A$ erforderlich.

Diese Einrichtung zur Erzeugung des abgeleiteten Signals $u_A$ kann beispielsweise aus der in Figur 7 gezeigten Einrichtung zur Weiterverarbeitung des Zwischenfrequenzsignals ZF aus dem Verstärker 6 zum Ausgangssignal des Überlagerungsempfängers bestehen, die einen Demodulator 7 zur Demodulation des ZwischenfrequenzsignalS ZF, ein zur Elimination von Rauschen dienendes Tiefpaßfilter 8 zur Tiefpaßfilterung des vom Demodulator 7 abgegebenen demodulierten Signals und eine vom Takt einer Taktrückgewinnungsschaltung 10 getaktete Entscheiderschaltung 9 zur Regeneration des vom Tiefpaßfilter 8 abgegebenen Signals aufweist. Die Entscheiderschaltung 9 gibt das regenerierte Ausgangssignal an einem Ausgang 90 ab. Die Taktrückgewinnungsschaltung 10 gewinnt den im zugeführten Signal enthaltenen Takt zurück. Dieses zugeführte Signal ist in Figur 7 das Signal aus dem Tiefpaßfilter 8, könnte aber ebenso gut das dem Tiefpaßfilter 8 zugeführte demodulierende Signal aus dem Demodulator 7 sein.

Bei dieser Einrichtung nach Figur 7 ist das am Ausgang 90 der Entscheiderschaltung 9 entnehmbare Signal bei den üblicherweise niedrigen Bitfehlerraten, die kleiner oder gleich $10^{-9}$ sind, eine äußerst getreue Replik der modulierenden Spannung $u_M$. Demnach kann dieses Ausgangssignal als das aus dem Zwischenfrequenzsignal ZF abgeleitete und der modulierenden Spannung $u_M$ entsprechende Signal $u_A$ verwendet werden. Dieses abgeleitete Signal $u_A$ wird dem Ausgang 90 direkt entnommen oder gemäß Figur 7 an einem Abzweigpunkt 91 abgezweigt, der in Figur 11 gezeigten Einrichtung 15 zur quantisierten Rückkopplung dieses abgeleiteten Signals $u_A$ zum Eingang 30 des das Referenzsignal R erzeugenden Referenzsignalsenders 3 und zum Verzerren dieses abgeleiteten Signals $u_A$ mit der zumindest annähernd der Übertragungsfunktion $F(f_m)$ des Signalsenders 1 gleichen Übertragungsfunktion $F_{QR}(f_m)$ zugeführt. Der Referenzsignalsender 3 ist dabei ein durch das verzerrte abgeleitete Signal $U_{QR}$ aus der Einrichtung 15 zur quantisierten Rückkopplung frequenzmodulierbarer optischer Sender.

Die durch den die oben definierte Modulationssteilheit $\delta f/\delta u_M = a + bF(f_m)$ mitbestimmenden Faktor b verursachte Änderung der Zwischenfrequenz $f_{ZF}$ kann bei diesem Ausführungsbeispiel weitgehend eliminiert werden, was im folgenden gezeigt wird.

Es gilt im Frequenzbereich

$$f_s(f_m) = f_{s0} + (a + bF(f_m)) \cdot u_M(f_m)$$
$$f_R = f_{R0} + c_1 F_{QR}(f_m) \cdot u_A(f_m)$$

wobei $f_{s0}$ und $f_{R0}$ mittlere Frequenzen des frequenzmodulierten optischen Signals S bzw. des optischen Referenzsignals sind, die so gewählt sind, daß die gewünschte mittlere Zwischenfrequenz $f_{ZF0} = f_{s0} - f_{R0} = (f_0 + f_1)/2$ ist, wobei $c_1$ eine sich aus einer Frequenzmodulationssteilheit des modulierbaren Frequenzsignalsenders 3 und einer gewählten Grundverstärkung der Einrichtung 15 zur quantisierten Rückkopplung sich ergebende Proportionalitätskonstante ist, und wobei $u_A(f_m)$ ein moduliertes abgeleitetes Signal ist, das der modulierenden Spannung $u_M$ entspricht. Unter der Voraussetzung, daß $F_{QR}(f_m)$ zumindest annähernd gleich $F(f_m)$ und $u_A$ zumindest annähernd gleich $u_M$ ist und daß $c_1$ zumindest annähernd gleich b gewählt wird, ergibt sich für die Zwischenfrequenz $f_{ZF} = f_s - f_R$ zumindest annähernd

$$f_{ZF} = f_{s0} - f_{R0} + a.u_m(f_m) = (f_0 + f_1)/2 + a.u_M(f_m),$$

d.h. die durch b verursachten Zwischenfrequenzänderungen sind eliminiert.

Die quantisierte Rückkopplung führt dem Referenzsignalsender 3 vorteilhafterweise nur deterministische Signale und kein Rauschen zu. Deshalb ist dieses Verfahren bis zu recht hohen Frequenzen brauchbar.

Die quantisierte Rückkopplung wird erst nach einer Signallaufzeit $t_0$ in der geschlossenen Schleife von der optischen Koppeleinrichtung 4 über den optischen Empfänger mit den Positionen 5 bis 9 in Figur 5, die Einrichtung 15 zur quantisierten Rückkopplung und den Referenzsignalsender 3 zurück zur Koppeleinrichtung 4 wirksam. Als Forderung besteht, daß der Term $bF(f_m)$ in der vorstehenden Gleichung für $f_s(f_m)$ ausgeglichen wird. Da $F(f_m)$ bis zur obengenannten zweiten Frequenz $f_h$ nennenswerte Anteile hat, muß wenigstens näherungsweise

$$t_0 < 1/(2\pi f_h)$$

gelten. Für $f_h = 10$ MHz gilt als Obergrenze $t_0 = 16$ ns, was mit vertretbarem technischem Aufwand zu realisieren ist.

Um beim Ausführungsbeispiel nach Figur 11 das Idealverhalten nach Figur 3b des frequenzmodulierten Signals möglichst genau zu erreichen, muß die Übertragungsfunktion $F(f_m)$ des Signalsenders 1 möglichst genau nachgebildet werden. Probleme treten hierbei dadurch auf, daß diese Übertragungsfunktion $F(f_m)$ von Sendelaser zu Sendelaser recht unterschiedlich ist. Abhilfe können die Ausführungsbeispiele nach den Figuren 12 und 13 schaffen.

Das Ausführungsbeispiel nach Figur 12 entspricht einer Kombination von schneller Frequenzregelung gemäß dem Ausführungsbeispiel nach Figur 7 mit der quantisierten Rückkopplung gemäß dem Ausführungsbeispiel nach Figur 11. Demnach ist bei diesem Ausführungsbeispiel sowohl der Frequenzdiskriminator 13 und die Regeleinrichtung 14 nach Figur 7 als auch die Einrichtung 15 zur quantisierten Rückkopplung nach Figur 11 vorhanden. Der Frequenzdiskriminator 13 wird mit dem vom Punkt 67 abgezweigten elektrischen Zwischenfrequenzsignal ZF und die Einrichtung 15 mit dem vom Punkt 91 abgezweigten abgeleiteten Signal $u_A$ beaufschlagt. Überdies ist eine Mischeinrichtung 16 zur Überlagerung des Ausgangssignals $U_s$ der Regeleinrichtung 14 und des von der Einrichtung 15 verzerrten abgeleiteten Signals $U_{QR}$ und zuführen dieser einander überlagerten Signale $U_s + U_{QS}$ zum Eingang 30 des frequenzmodulierbaren Referenzsignalsenders 3 vorhanden.

Diese Kombination hat den Vorteil, daß einerseits die Übertragungsfunktion $F_{QR}(f_m)$ der Einrichtung 15 zur quantisierten Richtkopplung nicht genau mit der Übertragungsfunktion $F(f_m)$ des Signalsenders 1 übereinstimmen muß, weil sie durch die Frequenzregelung mit dem Frequenzdiskriminator 13 und der Regeleinrichtung 14 unterstützt wird. Andererseits kann die Bandbreite $f_B$ der Frequenzregelschleife geringer gehalten werden, da die hochfrequenten Störanteile von der Einrichtung 15 zur quantisierten Rückkopplung ausgeregelt werden. Durch die geringere Bandbreite $f_B$ gelangt weniger Rauschen auf den Referenzfrequenzgenerator, was eine Verschlechterung der Empfängerempfindlichkeit verhindert.

Beim Ausführungsbeispiel nach Figur 12 könnte die Regelschleife mit dem Frequenzdiskriminator 13 und der Regeleinrichtung 14 auch durch eine konventionelle Frequenzregelung ersetzt werden, die sehr langsam und/oder nicht die Diskriminatorcharakteristik nach Figur 8 aufweist. Das Ausführungsbeispiel nach Figur 12 hat gegenüber einer derartigen Ausführungsform eine größere Reglerbandbreite.

Das Ausführungsbeispiel nach Figur 13 entspricht einer Kombination aus einer Vorverzerrung der modulierenden Spannung $u_M$ mit einer bestimmten quantisierten Rückkopplung. Zur Vorverzerrung der modulierenden Spannung $u_M$ ist eine Hochpaßfiltereinrichtung 21 mit einer bestimmten Hochpaßübertragungsfunktion $F_{HP}(f_m)$ zum Hochpaßfiltern der modulierenden Spannung $u_M$ vorgesehen.

Für die quantisierte Rückkopplung ist eine Einrichtung zur Erzeugung eines Zwischenfrequenzsignals ZF durch Überlagerung des vom Halbleiterlaser 1 abgegebenen frequenzmodulierten optischen Signals S und des von einem optischen Referenzsignalsender 3 erzeugten und eine bestimmte Referenzfrequenz $f_R$ aufweisenden Referenzsignals RS erforderlich. Diese Einrichtung kann durch die Koppeleinrichtung 4, den Photodetektor 5 und den Verstärker 6 nach Figur 7 realisiert sein.

Des weiteren ist eine Einrichtung zur Erzeugung eines aus dem Zwischenfrequenzsignal ZF abgeleiteten und der modulierenden Spannung $u_M$ zumindest annähernd entsprechenden Signals $U_A$ erforderlich, die durch den Diskriminator 10, den Demodulator 8, die Entscheiderschaltung 9 und die Taktrückgewinnungsschaltung 10 nach Figur 7 realisiert sein kann.

Das aus dem Zwischenfrequenzsignal ZF abgeleitete Signal $u_A$ ist einer Einrichtung 16 zur quantisierten Rückkopplung dieses abgeleiteten Signals $u_A$ zu dem das Referenzsignal R erzeugenden Referenzsignalsender, beispielsweise zum Eingang 30 des Referenzsignalsenders 3 nach Figur 7, und zum Verzerren des abgeleiteten Signals $u_A$ mit der zur Hochpaßübertragungsfunktion $F_{HP}(f_m)$ komplementären Tiefpaßübertragungsfunktion $1-F_{HP}(f_m)$ vorgesehen, wobei der Referenzsignalsender ein frequenzmodulierbarer optischer Sender sein muß, der durch das durch die Einrichtung 16 zur Erzeugung der quantisierten Rückkopplung verzerrte abgeleitete Signal $U_{QR}$ frequenzmodulierbar ist.

Bei diesem Ausführungsbeispiel nach Figur 11 sollte die Hochpaßübertragungseinrichtung 21 vorteilhafterweise im wesentlichen nur Frequenzen oberhalb der obengenannten vierten Frequenz $f_g$ durchlassen.

Im Frequenzbereich gilt

$$f_s(f_m) = f_{s0} + (a + bF(f_m))F_{HP}(f_m)u_M(f_m)$$
$$f_R = f_{R0} + c_1(1-F_{HP}(f_m))u_A(f_m)$$

wobei uA zumindest annähernd gleich $u_M$ ist. Wählt man überdies $c_1 = a$, so ergibt sich für die Zwischenfrequenz $f_{ZF} = f_s-f_R$:

$$f_{ZF} = f_{s0}-f_{R0} + (a + b(f_m)F_{HP}(f_m))u_M(f_m).$$

Wählt man ferner die vierte Frequenz fg größer als die zweite Frequenz fh, so haben F(fm) und FHP(fm) keinen oder nur einen vernachlässigbar kleinen Überlapp und es gilt zumindest annähernd

$$f_{ZF} = f_{s0}-f_{R0} + au_M(f_m),$$

d.h. die durch b verursachten Zwischenfrequenzänderungen sind auch hier eliminiert, so daß man vom unbekannten thermischen Laserfrequenzgang unabhängig ist, was bei der Lasercharakterisierung und bei der Schaltungsauslegung der Einrichtung 16 zur quantisierten Rückkopplung einen gewaltigen Kostenvorteil bedeutet.

Die Signallaufzeit t0 in der geschlossenen Schleife von der optischen Koppeleinrichtung 4 über den optischen Empfänger mit den Positionen 5 bis 9 in Figur 7, die Einrichtung 16 zur quantisierten Rückkopplung und den Referenzsignalgenerator 3 zurück zur Koppeleinrichtung 4 wird zur Eliminierung eines Störterms vorteilhafterweise kleiner als $1/2\pi f_g$ gewählt. Damit der Referenzsignalsender 3 schnelle Frequenzänderungen ausführen kann, wird außerdem fmax größer oder gleich $f_g$ gewählt.

Das Ausführungsbeispiel nach Figur 14 arbeitet mit Frequenzkonversion. Aus dem vom Halbleiterlaser 1 abgegebenen frequenzmodulierten optischen Signal S wird ein von der Modulationsfrequenz $f_m$ abhängiges Fehlersignal $U_{FE}$ erzeugt, das zumindest annähernd mit einer bestimmten Proportionalitätskontanten d.b proportional zum thermischen Tiefpaßanteil $F(f_m)$ der Frequenzübertragungsfunktion des Halbleiterlasers 1 und zur modulierenden Spannung $u_M$ ist.

Mit diesem elektrischen Fehlersignal $U_{FE}$ wird ein elektrisch steuerbarer Frequenzkonverter 17 gesteuert, der eine Frequenzkonversion der Signalfrequenz $f_s$ des frequenzmodulierten optischen Signals S bewirkt.

Die Proportionalitätskonstante d·b des Fehlersignals $U_{FE}$ wird so gewählt, daß die frequenzkonvertierte optische Frequenz $f'_s$ eines optischen Ausgangssignals S' an einem Ausgang 170 des Frequenzkonverters 17 erhalten wird, im wesentlichen proportional zur modulierenden Spannung $u_M$ ist und nicht vom thermischen Tiefpaßanteil $F(f_m)$ der Frequenzübertragungsfunktion des Halbleiterlasers 1 abhängt.

Ist der Frequenzkonverter 17 dadurch gekennzeichnet, daß die frequenzkonvertierte optische Frequenz $f_s'$ seines optischen Ausgangssignals S' von der Signalfrequenz $f_s$ des ihm zugeführten frequenzmodulierten optischen Signals S und von einer an einem Steuereingang 171 des Frequenzkonverters 17 anliegenden elektrischen Steuersignal $U_C$ derart abhängt, daß

$$f_s' = f_s + e.U_C + g$$

gilt, wobei g eine Konstante ist, die auch null sein kann, so erhält man mit der Wahl d = -1/e und $U_{FE} = U_C$ in Verbindung mit dem expliziten Ausdruck

$$f_s(f_m) = f_{so} + (a + b.F(f_m)) \cdot u_M(f_m)$$

für die Signalfrequenz $f_s$ des frequenzmodulierten optischen Signals S für die frequenzkonvertierte optische Frequenz $f_s'$ des optischen Ausgangssignale S' des Frequenzkonverters 170 den Ausdruck

$$f_s' = f_{so} + a.u_M(f_m) + g$$

wobei $f_{so}$ die konstante Trägerfrequenz des frequenzmodulierten optischen Signals S, $a.u_M(f_m)$ den gewünschten, von der Modulationsfrequenz $f_m$ unabhängigen glatten Frequenzgang, der die Verzerrungsfreiheit des frequenzkonvertierten optischen Signals S' anzeigt, und g einen Frequenzversatz gegenüber dem frequenzmodulierten optischen Signal aus dem Halbleiterlaser 1, der auch null sein kann, bedeuten.

Die Figur 14 zeigt die schaltungsmäßige Realisierung dieser Frequenzkonversion als Blockschaltbild. Das frequenzmodulierte optische Signal aus dem Halbleiterlaser 1 ist einem Eingang 190 eines optischen Aufteilers 19 mit zwei Ausgängen 191 und 192 zugeführt. Dieser Aufteiler 19 teilt das zugeführte frequenzmodulierte optische Signal S in einen dem Ausgang 191 zugeführten Signalanteil und einen dem Ausgang 192 zugeführten Signalanteil auf. Der Signalanteil aus dem Ausgang 191 ist einem Eingang 172 des Frequenzkonverters 17 zur Frequenzkonversion zugeführt. Der Anteil aus dem Ausgang 192 ist einem Eingang 184 eines Fehlersignalerzeugers 18 zugeführt, der in Abhängigkeit von diesem zugeführten Signalanteil ein elektrisches Fehlersignal $U_{FE}$ einem Eingang 185 erzeugt, das dem Steuereingang 171 des Frequenzkonverters 17 zugeführt ist.

Eine konkrete Realisierung des Aufteilers 19 und des Fehlersignalerzeugers 18 kann in den Schaltungsteil der Figur 7 bestehen, der gegeben ist durch den optischen Richtkoppler 4, den Photodetektor 5, den Verstärker 6 und den mit dem Verstärker 6 über den Punkt 67 verbundenen Frequenzdiskriminator 13, dessen Ausgangssignal $U_{DISK}$ als Fehlersignal $U_{FE}$ verwendet wird, das dem Eingang 171 des Frequenzkonverters 17 zugeführt wird. Das freie, nicht dem Photodetektor 5 gegenüberliegende in Figur 7 rechte Ende des Richtkopplers 4 bildet den Ausgang des Aufteilers, der mit dem Eingang 172 des Frequenzkonverters 17 zu verbinden ist. Die Positionen 14 und 3 wie auch die Positionen 7 bis 10 in Figur 7 entfallen für die Schaltung nach Figur 14.

**Patentansprüche**

1. Verfahren zur Erzeugung eines frequenzmodulierten optischen Signals (S), insbesondere für die optische Nachrichtentechnik, durch Pumpen eines Halbleiterlasers (1) mit einer an eine Pumpelektrode (11) dieses Lasers (1) angelegten und mit einer Modulationsfrequenz $f_m$ modulierenden elektrischen Spannung ($u_M$), wobei der Halbleiterlaser (1) eine Frequenzübertragungsfunktion mit einem von der Modulationsfrequenz ($f_m$) abhängigen thermischen Tiefpaßanteil ($F(f_m)$) aufweist, der eine Verzerrung des erzeugten frequenzmodulierten optischen Signals (S) bewirkt,

**dadurch gekennzeichnet,**

daß zur Erzeugung eines von der durch den thermischen Tiefpaßanteil ($F(f_m)$) bedingten Verzerrung ganz oder teilweise freien frequenzmodulierten Signals (S)

    a) ein Halbleiterlaser (1) verwendet wird, der neben der Pumpelektrode (11) eine weitere Elektrode (12) zum Anlegen der modulierenden Spannung ($u_M$) aufweist, wobei die an die Pumpelektrode (11) angelegte modulierende Spannung ($u_M$) und die an die weitere Elektrode (12) angelegte modulierende Spannung derart verzerrt werden, daß die verzerrten modulierenden Spannungen ($u_M$) zusammen die Verzerrung des frequenzmodulierten optischen Signals (S) ganz oder teilweise kompensieren, und/oder

    b) das frequenzmodulierte optische Signal (S) selbst in bezug auf eine Signalfrequenz ($f_s$) dieses Signals (S) einer eine Verzerrung dieses Signals (S) ganz oder teilweise kompensierenden Verzerrung unterworfen wird, und/oder

    c) durch Überlagerung des frequenzmodulierten optischen Signals (S) mit einem optischen Referenzsignal (RS) einer bestimmten modulierbaren Referenzfrequenz ($f_R$) ein frequenzmoduliertes optisches Überlagerungssignal ($U_{SR}$) erzeugt und das Referenzsignal (RS) in Bezug auf die Referenzfrequenz ($f_R$) einer eine in dem Überlagerungssignal ($U_{SR}$) enthaltene Verzerrung des frequenzmodulierten optischen Signals ganz oder teilweise kompensierenden Verzerrung unterworfen wird.

2. Verfahren nach Anspruch 1,
**dadurch gekennzeichnet,**
daß ein Halbleiterlaser (1) verwendet wird, dessen Frequenzübertragungsfunktion in bezug auf die an die Pumpelektrode (11) angelegte modulierende Spannung ($u_M$) zumindest annähernd eine lineare Funktion ($a + bF(f_m)$) des thermischen Tiefpaßanteils ($F(f_m)$) ist.

3. Verfahren nach Anspruch 2,
**dadurch gekennzeichnet,**
    - daß die lineare Funktion ($a + bF(f_m)$) des thermischen Tiefpaßanteils ($F(f_m)$) einen

Proportionalitätsfaktor (b) des thermischen Tiefpaßanteils ($F(f_m)$) und eine additive Konstante (a) aufweist,

    - daß die additive Konstante (a) und die Summe ($a + b$) aus dieser additiven Konstanten (a) und dem Proportionalitätsfaktor (b) des thermischen Tiefpaßanteils ($F(f_m)$) jeweils ein positiver Zahlenwert sind, und

    - daß sowohl die der Pumpelektrode (11) als auch der weiteren Elektrode (12) zuzuführende modulierende Spannung ($u_M$) mit jeweils einem Filter (181, 183, 181, 182, 183)) derart verzerrt wird, daß die Verzerrung des frequenzmodulierten optischen Signals (S) ganz oder teilweise kompensiert wird.

4. Verfahren nach Anspruch 2,
**dadurch gekennzeichnet,**
    - daß die lineare Funktion ($a + bF(f_m)$ des thermischen Tiefpaßanteils ($F(f_m)$) einen Proportionalitätsfaktor (b) des thermischen Tiefpaßanteils ($F(f_m)$) und eine additive Konstante (a) aufweist,

    - daß die additive Konstante (a) und die Summe ($a + b$) aus dieser additiven Konstanten (a) und dem Proportionalitätsfaktor (b) des thermischen Tiefpaßanteils ($F(f_m)$) jeweils ein negativer Zahlenwert sind, und

    - daß zumindest die der Pumpelektrode (11) zuzuführende modulierende Spannung ($u_M$) mit zumindest einem Filter (181, 182) derart verzerrt wird, daß die Verzerrung des frequenzmodulierten Signals (S) ganz oder teilweise kompensiert wird.

5. Verfahren nach einem der Ansprüche 1 bis 4,
**dadurch gekennzeichnet,**
daß der Laser (1) in bezug auf die an die weitere Elektrode (12) angelegte modulierende Spannung ($u_M$) eine von der Modulationsfrequenz ($f_m$) abhängige Übertragungsfunktion ($cF_a(f_m)$) aufweist, die gleich einer mit einer auf die weitere Elektrode (12) bezogenen bestimmten Proportionalitätskonstante (c) multiplizierten Tiefpaßübertragungsfunktion ($F_a(f_m)$) ist, welche für kleine Modulationsfrequenzen ($f_m$) den Wert 1 und für sehr große Modulatinsfrequenzen ($f_m$) den Wert 0 aufweist.

6. Verfahren nach Anspruch 2 und 5,
**dadurch gekennzeichnet,**
daß die modulierende Spannung($u_M$) der Pumpelektrode (11) hochpaßgefiltert und der weiteren Elektrode (12) tiefpaßgefiltert zugeführt wird.

7. Verfahren nach einem der vorhergehenden Ansprüche, insbesondere nach Anspruch 6, **dadurch gekennzeichnet,** daß als Halbleiterlaser (1) ein TTG-Laser verwendet wird.

8. Verfahren nach einem der Ansprüche 2 bis 7, **dadurch gekennzeichnet,**
   - daß ein Halbleiterlaser (1) verwendet wird, bei dem Frequenzbereichew der Modulationsfrequenz ($f_m$), in denen
   - der Betrag ($|\delta f/\delta u_M|$) einer auf die Pumpelektrode (11) bezogenen Modulationssteilheit ($\delta f/\delta u_M$), die gegeben ist durch das von der Modulationsfrequenz ($f_m$) abhängige Verhältnis zwischen einer Änderung ($\delta f$)der Signalfrequenz ($f_s$) des frequenzmodulierten optischen Signals (S) und einer Änderung ($\delta u_M$) der an die Pumpelektrode (11) anzulegenden modulierenden Spannung ($u_M$) und/oder
   - der Betrag($|\delta f/\delta u_M|$) einer auf die weitere Elektrode (12) bezogenen Modulationssteilheit ($\delta f/\delta u_M$), die gegeben ist durch das von der Modulationsfrequenz ($f_m$) abhängige Verhältnis zwischen einer Änderung ($\delta f$) der Signalfrequenz ($f_s$) des frequenzmodulierten optischen Signals (S) und einer diese Änderung ($\delta f$) verursachenden Änderung ($\delta u_M$) der an die weitere Elektrode (12) anzulegenden modulierenden Spannung ($u_M$)
   - einen zumindest annähernd flachen Verlauf aufweisen, den gesamten Bereich zwischen einer kleinsten ersten Frequenz (0) und einer im Vergleich zu dieser ersten Frequenz größeren zweiten Frequenz ($f_r$) umfassen.

9. Verfahren nach Anspruch 8, **dadurch gekennzeichnet**, daß ein Halbleiterlaser (1) verwendet wird, bei dem der Betrag ($|\delta f/\delta u_M|$) der auf die Pumpelektrode (11) bezogenen Modulationssteilheit ($\delta f/\delta u_M$) zumindest in einem Frequenzbereich zwischen einer im Vergleich zur ersten Frequenz (0) größeren und im Vergleich zur zweiten Frequenz ($f_r$) kleineren bestimmten dritten Frequenz ($f_t$) der Modulationsfrequenz ($f_m$), sowie für Modulationsfrequenzen ($f_m$), die größer als eine bestimmte, im Vergleich zur dritten Frequenz ($f_t$) größere vierte Frequenz ($f_h$) sind, einen zumindest annähernd flachen Verlauf aufweist, und bei dem der Betrag ($|\delta f/\delta u_M|$) der auf die weitere Elektrode (12) bezogenen Modulationssteilheit ($\delta f/\delta u_M$) mindestens in einem Frequenzbereich zwischen der ersten Frequenz (0) und einer im Vergleich zur vierten Frequenz ($f_n$) größeren fünften Frequenz ($f_{max}$) der Modulationsfrequenz ($f_m$) zumindest näherungsweise einen flachen Verlauf aufweist.

10. Verfahren nach einem der Ansprüche 1 bis 9, **dadurch gekennzeichnet,**
    - daß aus dem vom Halbleiterlaser (1) abgegebenen frequenzmodulierten optischen Signal (S) ein elektrisches Fehlersignal ($U_{FE}$) erzeugt wird, das zumindest annähernd mit einer bestimmten Proportionalitätskonstante (d.b) proportional zum thermischen Tiefpaßanteil ($F(f_m)$) der Frequenzübertragungsfunktion des Halbleiterlasers (1) und zur modulierenden Spannung ($u_M$) ist,
    - daß mit diesem Fehlersignal ($U_{FE}$) ein steuerbarer Frequenzkonverter (17) gesteuert wird, welcher eine Frequenzverschiebung der Signalfrequenz ($f_s$) des frequenzmodulierten optischen Signals (S) bewirkt, und
    - daß die Proportionalitätskonstante (d·b) des Fehlersignals ($U_{FE}$) so gewählt wird, daß die optische Frequenz ($f_s'$) eines optischen Ausgangssignals (S') an einem Ausgang (170)des Frequenzkonverters (17) im wesentlichen proportional zur modulierten Spannung ($u_M$) ist und nicht vom thermischen Tiefpaßanteil ($F(f_m)$) der Frequenzübertragungsfunktion des Halbleiterlasers (1) abhängt.

11. Verfahren nach Anspruch 1 oder 10, **dadurch gekennzeichnet,** daß ein von einer Zwischenfrequenz ($f_{ZF}$) eines aus dem Überlagerungssignal ($U_{SR}$) gewonnenen Zwischenfrequenzsignals ($U_{ZF}$) abhängiges Amplitudensignal ($U_{DISK}$) derart erzeugt wird, daß dieses Amplitudensignal ($U_{DISK}$) in Bezug auf einen bestimmten Amplitudenpegel ($P_0$) zumindest zwei in einer gleichen Richtung (r) geneigte Pegeldurchgange ($d_0$, $d_1$) bei zwei bestimmten, voneinander verschiedenen Kennfrequenzwerten ($f_0$, $f_1$) der Zwischenfrequenz ($f_{ZF}$) aufweist, und daß im Idealfall, daß das vom Halbleiterlaser (1) abgegebene frequenzmodulierte optische Signal (S) unverzerrt ist, Zwischenfrequenzwerte auftreten, die gleich diesen Kennfrequenzwerten ($f_0$, $f_1$) sind, und daß bei einer frequenzmäßigen Abweichung der Zwischenfrequenzwerte von den Kennfrequenzwerten ($f_0$, $f_1$) die Zwischenfrequenzwerte durch eine durch ein aus einem laufend ermittelten Amplitudenpegel (P) des Amplitudensignals ($U_{DISK}$) erzeugtes Ausgangssignal ($U_S$) bewirkte Änderung der Referenzfrequenz ($f_R$) des Referenzsignals (RS) wieder zumindest annähernd auf die Kennfrequenzwerte ($f_0$, $f_1$) zurückgeregelt werden.

12. Verfahren nach einem der Ansprüche 1 bis 11, **dadurch gekennzeichnet,** daß von einem aus dem optischen Überlagerungssignal ($U_{SR}$) gewonnenen Zwischenfrequenzsignal ($U_{ZF}$) ein Signal ($u_A$) abgeleitet wird, das der modulierenden Spannung ($u_M$) entspricht, und daß das abgeleitete Signal ($u_A$) mittels einer von der Modulationsfrequenz ($f_m$) abhängigen Tiefpaßfilteranteil ($F(f_m)$) der Frequenzübertragungsfunktion ($F_{QR}(f_m)$), die zumindest annähernd gleich einer von der Modulationsfrequenz ($f_m$) abhängigen Übertragungsfunktion ($F(f_m)$) des Halbleiterlasers (1) ist, verzerrt und dieses verzerrte Signal ($U_{QR}$) zur Erzeugung einer dem Referenzsignal (R) aufgeprägten Frequenzmodulation zur vollständigen oder teilweisen Kompensation der im Zwischenfrequenzsignal ($U_{ZF}$) enthaltenen Verzerrung des frequenzmodulierten optischen Signals (S) verwendet wird.

13. Verfahren nach Anspruch 11 und 12, **dadurch gekennzeichnet,** daß das von der Zwischenfrequenz ($f_{ZF}$) abhängige Signal ($U_{DISK}$) laufend darauf überprüft wird, ob bei diesen Kennfrequenzwerten ($f_0$, $f_1$) eine Abweichung des tatsächlichen Amplitudenpegels (P) dieses Signals ($U_{DISK}$) von dem bestimmten Amplitudenpegel ($P_0$) und somit eine Abweichung der Zwischenfrequenzwerte von den Kennfrequenzwerten ($f_0$, $f_1$) vorliegt, daß ein von einer solchen Abweichung abhängiges Ausgangssignal ($U_S$) erzeugt wird, und daß dieses Ausgangssignal ($U_S$) und das verzerrte Signal ($U_{QR}$) einander überlagert zu einer Änderung der Referenzfrequenz ($f_R$) des Referenzsignals (RS) zur vollständigen oder teilweisen Kompensation der im Überlagerungssignal ($U_{SR}$) enthaltenen Verzerrung des frequenzmodulierten optischen Signals (S) verwendet werden.

14. Verfahren nach einem der Ansprüche 1 bis 13, **dadurch gekennzeichnet,** daß von einem aus dem Überlagerungssignal ($U_{SR}$) gewonnenen Zwischenfrequenzsignal ($U_{ZF}$) ein Signal ($u_A$) abgeleitet wird, das der modulierenden Spannung ($U_M$) entspricht, daß die modulierende Spannung ($u_M$) durch eine Hochpaßübertragungsfunktion ($F_{HP}(f_m)$) für die Modulationsfrequenz (fm) vorverzerrt dem Halbleiterlaser (1) zugeführt wird, und daß das abgeleitete Signal ($u_A$) durch eine zur Hochpaßübertragungsfunktion ($F_{HP}(f_m)$) wenigstens

näherungsweise komplementäre Tiefpaßübertragungsfunktion (etwa $1-F_{HP}(f_m)$) der Modulationsfrequenz ($f_m$) verzerrt und dieses verzerrte Signal ($U_{QR}$) zur Erzeugung einer dem Referenzsignal (RS) aufgeprägten Frequenzmodulation zur vollständigen oder teilweisen Kompensation einer im Überlagerungssignal ($U_{SR}$) enthaltenen Verzerrung des frequenzmodulierten optischen Signals (S) verwendet wird.

15. Einrichtung zur Durchführung eines Verfahrens nach einem der Ansprüche 6 oder 7, **gekennzeichnet durch**

- eine Hochpaßfiltereinrichtung (21) zum Hochpaßfiltern der der Pumpelektrode (11) des Halbleiterlasers (1) zuzuführenden modulierenden Spannung ($u_M$) und
- eine Tiefpaßfiltereinrichtung (22) zum Tiefpaßfiltern der der weiteren Elektrode (12) des Halbleiterlasers (1) zuzuführenden modulierenden Spannung ($u_M$),
- wobei die Tiefpaßfiltereinrichtung (22) eine vorbestimmte Tiefpaßübertragungsfunktion ($F_{TP}(f_m)$) für die Modulationsfrequenz ($f_m$) aufweist, die für Modulationsfrequenzen ($f_m$), die sehr klein gegenüber einer sechsten Frequenz ($f_g$) sind, im wesentlichen den Wert 1 und für Modulationsfrequenzen ($f_m$), die sehr groß gegenüber der sechsten Frequenz ($f_g$) sind, im wesentlichen den Wert 0 annimmt, und
- wobei die Hochpaßübertragungsfunktion ($F_{HP}(f_m)$) der Hochpaßfiltereinrichtung (21) gleich dem Wert 1 abzüglich der Tiefpaßübertragungsfunktion ($F_{TP}(f_m)$) der Tiefpaßfiltereinrichtung (22) ist.

16. Einrichtung nach Anspruch 15, **dadurch gekennzeichnet,** daß die sechste Frequenz ($f_g$) zwischen der vierten Frequenz ($f_h$) und der fünften Frequenz ($f_{max}$) liegt.

17. Einrichtung nach Anspruch 15 oder 16, **gekennzeichnet durch** eine der Tiefpaßfiltereinrichtung (22) vor- oder nachgeschaltete Multipliziereinrichtung (23) zum Multiplizieren der ungefilterten oder durch diese Tiefpaßfiltereinrichtung (22) gefilterten modulierenden Spannung ($u_M$) mit einem Faktor ($a/c$), der gleich der durch die auf die weitere Elektrode (12) bezogene bestimmte Proportionalitätskonstante (c) dividierten additiven Konstante (a) der Frequenzübertragungsfunktion in Form der linearen Funktion ($a+bF(f_m)$) des thermischen Tiefpaßanteils ($F(f_m)$) dieser Frequenzübertragungsfunktion ($a+bF(f_m)$) ist.

**18.** Einrichtung nach Anspruch 15 oder 16, **gekennzeichnet durch** eine der Hochpaßfiltereinrichtung (21) vor- oder nachgeschaltete Multipliziereinrichtung (24) zum Multiplizieren der ungefilterten oder durch diese Hochpaßfiltereinrichtung (21) gefilterten modulierenden Spannung ($u_M$) mit einem Faktor (c/a), der gleich der durch die additive Konstante (a) der Frequenzübertragungsfunktion in Form der linearen Funktion (a + bF(fm)) des thermischen Tiefpaßanteils (F(fm)) dieser Frequenzübertragungsfunktion (a + bF($f_m$)) dividierten, auf die weitere Elektrode (12) bezogenen bestimmten Proportionalitätskonstanten (c) ist.

**19.** Einrichtung nach einem der Ansprüche 15 bis 18, **dadurch gekennzeichnet,** daß die Hochpaßfiltereinrichtung (21) eine in einen zur Pumpelektrode (11) des Halbleiterlasers (1) führenden Signalpfad (201) für die modulierende Spannung($u_M$) geschalteten Kapazität (210) und einen zwischen diesen Signalpfad (201) und ein Bezugspotential (E) geschalteten Widerstand (211) aufweist.

**20.** Einrichtung nach einem der Ansprüche 16 bis 19, **dadurch gekennzeichnet,** daß die Tiefpaßfiltereinrichtung (22) einen in einen zur weiteren Elektrode (12) des Halbleiterlasers (1) führenden Signalpfad (202) für die modulierende Spannung ($u_M$) geschalteten Widerstand (220) und eine zwischen den zweiten Signalpfad (202) und ein Bezugspotential (E) geschaltete Kapazität (221) aufweist.

**21.** Einrichtung nach einem der Ansprüche 15 bis 19, insbesondere nach Anspruch 19, **dadurch gekennzeichnet,** daß die Tiefpaßfiltereinrichtung (22) eine in einem zur weiteren Elektrode (12) des Halbleiterlasers (1) führenden Signalpfad (202) für die modulierende Spannung ($u_M$) geschaltete Induktivität (222) und einen zwischen diesen Signalpfad (202) und das Bezugspotential (E) geschalteten Widerstand (223) aufweist.

**22.** Einrichtung nach Anspruch 19 und 20, **dadurch gekennzeichnet,** daß ein Kapazitätswert ($C_1$) der Kapazität (210) und ein Widerstandswert ($R_2$) des Widerstandes (211) der Hochpaßfiltereinrichtung (21) sowie ein Widerstandswert ($R_1$) des Widerstandes (220) und ein Kapazitätswert ($C_2$) der Kapazität (221) der Tiefpaßfiltereinrichtung (22) so gewählt sind, daß ein aus dem Kapazitätswert ($C_1$) und dem Widerstandswert ($R_1$) gebildetes Produkt ($C_1 R_1$) der Hochpaßfiltereinrichtung (21) gleich einem aus dem Widerstandswert ($R_2$) und dem Kapazitätswert ($C_2$) der Tiefpaßfiltereinrichtung (22) gebildeten Produkt ($R_2 C_2$)ist.

**23.** Einrichtung nach Anspruch 19 und 21, **dadurch gekennzeichnet,** daß ein Kapazitätswert ($C_1$) der Kapazität (210) und ein widerstandswert ($R_1$) des Widerstandes (211) der Hochpaßfiltereinrichtung (21) sowie ein Induktivitätswert (L) der Induktivität (222) und ein Widerstandswert ($R_3$) des Widerstandes (223) der Tiefpaßfiltereinrichtung (22) so gewählt sind, daß ein aus dem Kapazitätswert ($C_1$) und dem Widerstandswert ($R_1$) der Hochpaßfiltereinrichtung (21) gebildetes Produkt ($C_1 R_1$) gleich einem aus dem Induktivitätswert (L) der Tiefpaßfiltereinrichtung (22) dividiert durch deren Widerstandswert ($R_3$) gebildeten Quotienten (L/$R_3$) ist.

**24.** Einrichtung zur Durchführung eines Verfahrens nach Anspruch 11, **gekennzeichnet durch**
- einen Frequenzdiskriminator (13) zum Erzeugen des von der Zwischenfrequenz ($f_{FZ}$) abhängigen Amplitudensignals ($U_{DISK}$) aus dem Zwischenfrequenzsignal (ZF) und
- eine Regeleinrichtung (14), bei der ein laufend ermittelter Amplitudenpegel (P) des Amplitudensignals ($U_{DISK}$) als ein Istwert und der bestimmte Amplitudenpegel ($P_0$) als ein Sollwert benutzt ist, und die ein von einer Abweichung dieses Istwertes (P) von diesem Sollwert abhängiges Ausgangssignal ($U_s$) erzeugt, das einem das Referenzsignal (RS) erzeugenden, frequenzmodulierbaren optischen Referenzsignalsender (3) als ein Steuersignal zu einer Änderung der Referenzfrequenz ($f_R$) des Referenzsignals (RS) derart, daß die Abweichung des Istwertes (P) vom Sollwert ($P_0$) zumindest näherungsweise beseitigt wird, zugeführt ist.

**25.** Einrichtung nach Anspruch 24, **gekennzeichnet durch** einen das Referenzsignal (RS) erzeugenden frequenzmodulierbaren optischen Referenzsignalsender (3) mit einer Frequenzmodulationscharakteristik, die über einem für das frequenzmodulierte optische Signal (S) vorgesehenen Modulationsfrequenzbereich zumindest annähernd konstant ist.

**26.** Einrichtung nach Anspruch 25, **dadurch gekennzeichnet,** daß der das Referenzsignal (RS) erzeugende, frequenzmodulierbare Referenzsignalsender (3) einen abstimmbaren TTG-Laser aufweist.

**27.** Einrichtung zur Durchführung eines Verfahrens nach Anspruch 12 oder13, **gekennzeichnet durch**

- eine Einrichtung (4) zur Erzeugung eines optischen Überlagerungssignals (U_{SR}) durch Überlagerung des vom Halbleiterlaser (1) abgegebenen frequenzmodulierten optischen Signals (S) und des von einem optischen ReferenzHalbleiterlaser (3) erzeugten und die bestimmte Referenzfrequenz (f_R) aufweisenden Referenzsignals (RS),

- eine Einrichtung (5, 6) zur Erzeugung eines elektrischen Zwischenfrequenzsignals (U_{ZF}) aus dem optischen Überlagerungssignal (U_{SR})

- eine Einrichtung (7, 8, 9, 10) zur Erzeugung des der modulierenden Spannung (u_M) zumindest annähernd entsprechenden abgeleiteten Signals (u_A) aus dem Zwischenfrequenzsignal (U_{ZF}), und durch

- eine Einrichtung (15) zur quantisierten Rückkopplung des abgeleiteten Signals (u_A) zu dem das Referenzsignal (R) erzeugenden Referenzsignalsender (3) und zum Verzerren des abgeleiteten Signals (u_A) mit der zumindest annähernd dem Tiefpaßanteil (F(f_m)) der Frequenzübertragungsfunktion (a+bF(fm)) des Halbleiterlasers (1) gleichen Übertragungsfunktion (F_{QR}(f_m)),

- wobei der Referenzsignalsender (3) ein durch das verzerrte abgeleitete Signal (U_{QR}) aus der Einrichtung (15) zur quantisierten Rückkopplung frequenzmodulierbarer optischer Sender ist.

**28.** Einrichtung nach einem der Ansprüche 24 bis 26 und Anspruch 27 zur Durchführung eines Verfahrens nach Anspruch 8, **gekennzeichnet durch** eine Addier- oder Subrahiereinrichtung (16) zur Überlagerung des von einer Abweichung des Istwertes (P) vom Sollwert (P_0) abhängigen Ausgangssignals (U_s) und des verzerrten abgeleiteten Signals (U_{QR}) und Zuführen dieser einander überlagerten Signale (U_s+U_{QR}) zum frequenzmodulierbaren Referenzsignalsender (3).

**29.** Einrichtung zur Durchführung eines Verfahrens nach Anspruch 14, **gekennzeichnet durch**

- eine Hochpaßfiltereinrichtung (21) mit der bestimmten Hochpaßübertragungsfunktion (F_{HP}(f_m)) zum Hochpaßfiltern der an die Pumpelektrode (11) des Halbleiter laser (1) anzulegenden modulierenden Spanung (u_M),

- eine Einrichtung (4) zur Erzeugung eines optischen Überlagerungssignals (U_{SR}) durch Überlagerung des vom Halbleiterlaser (1) abgegebenen frequenzmodulierten optischen Signals (S) und des von einem optischen Referenzsignalsender (3) erzeugten und die bestimmte Referenzfrequenz (f_R) aufweisenden optischen Referenzsignals (R),

- eine Einrichtung (5 bis 10) zur Erzeugung des dem Modulationssignal (U) zumindest annähernd entsprechenden abgeleiteten Signals (u_A) aus dem optischen Überlagerungssignal (U_{SR}), und durch

- eine Einrichtung (16) zur quantisierten Rückkopplung des abgeleiteten Signals (u_A) zu dem das Referenzsignal (RS) erzeugenden ReferenzHalbleiterlaser (3) und zum Verzerren des abgeleiteten Signals (u_A) mit der zur Hochpaßübertragungsfunktion (F_{HP}(f_m)) zumindest annähernd komplementären Tiefpaßübertragungsfunktion (1-F_{HP}(f_m)),

- wobei der Referenzhalbleiterlaser (3) ein durch das verzerrte abgeleitete Signal (U_{QR}) frequenzmodulierbarer optischer Sender ist.

**30.** Einrichtung zur Durchführung eines Verfahrens nach Anspruch 10, **gekennzeichnet durch**

- einen optischen Aufteiler (19) zum Aufteilen des frequenzmodulierten optischen Signals (S) in zwei Signalteile,

- einen steuerbaren Frequenzkonverter (17), dem einer der beiden Signalanteile zugeführt ist und der in Abhängigkeit von einem zugeführten Steuersignal eine Frequenzkonversion an dem zugeführten Signalanteil vornimmt, und

- einen Fehlersignalerzeuger (18), dem der andere Signalanteil zugeführt ist und der in Abhängigkeit von diesem Signalanteil ein Fehlersignal (U_{FE}) erzeugt, das dem Frequenzkonverter (17) als Steuersignal zugeführt ist.

FIG 1

$U_M$, $f_m$

181

182

182

11

1

$a + b$ $F(f_m)$
$c F_a(f_m)$

S, $f_s$

12

FIG 2

$\left|\dfrac{\delta f}{\delta U_M}\right|$ c

II

b+a

I

a

0   $f_t$        $f_h$      $f_{max}$                    $f_r$

FIG 3a

$f_s$, $f_{ZF}$

BM1

S

BM2

$f_1$
$f_0$

$t_A$     $t_B$     $t_C$     t

FIG 3b

$f_s$, $f_{ZF}$

S

$f_1$
$f_0$

$t_A$     $t_B$     t

FIG 4

FIG 5a

FIG 5b

FIG 5c

FIG 6a

FIG 6b

FIG 6c

FIG 7

FIG 8

FIG 9

FIG 10

FIG 11

$U_{QR}$

$U_A$

15

QR
$F_{QR}(f_m)$

30

91

90

$U_A$

FIG 12

30

$U_S + U_{QR}$

$U_S$

14

RE

$U_{DISK}$

67

DISK

13

$U_{QR}$

15

QR

16

91

90

$U_A$

$U, f_m$

$F_{HP}(f_m)$

$F(f_m)$

$S, f_s$

20

21

1

FIG 13

30

$U_{QR}$

16

QR
$1 - F_{QR}(f_m)$

91

90

$U_A$

$S, f_s$

19

190

191

192

184

$S, f_s$

18

185

$S, f_s$

172

171

$U_C$

17

170

$S', f_s'$

FIG 14

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| D,A | 16TH EUROPEAN CONFERENCE ON OPTICAL COMMUNICATION , ECOC 90 Bd. 1 , 16. September 1990 , AMSTERDAM, NL Seiten 181 - 184 K.DRÖGEMÜLLER ET AL 'Frequency Modulation Characteristics of tunable twin-guide (TTG) DFB Lasers' * Seite 181, Absatz 3 * * Seite 183, Absatz 3 * --- | 1,2,7 | H04B10/18 |
| A | EP-A-0 416 622 (ORTEL CORPORATION) * Zusammenfassung; Abbildung 2 * --- | 1 | |
| A | DE-A-33 07 309 (ROBERT BOSCH GMBH) * Zusammenfassung * --- | 1 | |
| A | PATENT ABSTRACTS OF JAPAN vol. 16, no. 154 (E-1190)15. April 1992 & JP-A-04 007 882 (MITSUBISHI ELECTRIC) * Zusammenfassung * ----- | 1 | |

RECHERCHIERTE SACHGEBIETE (Int.Cl.5)

H04B
H01S

Der vorliegende Recherchenbericht wurde für alle Patentansprüche erstellt

| Recherchenort | Abschlußdatum der Recherche | Prüfer |
|---|---|---|
| DEN HAAG | 4. November 1993 | GOUDELIS, M |